(19) Europäisches Patentamt / European Patent Office / Office européen des brevets

(11) **EP 2 744 070 B1**

(12) **EUROPEAN PATENT SPECIFICATION**

(45) Date of publication and mention
of the grant of the patent:
**05.10.2016 Bulletin 2016/40**

(51) Int Cl.:
***G01R 19/25*** (2006.01)   ***H04L 12/28*** (2006.01)
***H02J 3/14*** (2006.01)

(21) Application number: **12822663.6**

(22) Date of filing: **08.08.2012**

(86) International application number:
**PCT/JP2012/070240**

(87) International publication number:
**WO 2013/022035 (14.02.2013 Gazette 2013/07)**

(54) **SMART TAP**

INTELLIGENTER HAHN

DISPOSITIF D'ÉCOUTE INTELLIGENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.08.2011  JP 2011173359**

(43) Date of publication of application:
**18.06.2014  Bulletin 2014/25**

(60) Divisional application:
**15188568.8 / 2 991 192**

(73) Proprietor: **Nitto Denko Corporation
Ibaraki-shi, Osaka 567-8680 (JP)**

(72) Inventors:
 • **HIEDA Yoshihiro
   Ibaraki-shi
   Osaka 567-8680 (JP)**
 • **AOKI Hiroyuki
   Ibaraki-shi
   Osaka 567-8680 (JP)**

 • **MATSUYAMA Takashi
   Kyoto-shi
   Kyoto 606-8501 (JP)**
 • **KATO Takekazu
   Kyoto-shi
   Kyoto 606-8501 (JP)**

(74) Representative: **Grünecker Patent- und
Rechtsanwälte
PartG mbB
Leopoldstraße 4
80802 München (DE)**

(56) References cited:
**EP-A1- 2 667 473     JP-A- 2003 259 569
JP-A- 2004 064 136     JP-A- 2006 210 980
JP-A- 2009 165 249     US-A1- 2001 025 349**

 • **YUSUKE YAMADA ET AL: "Human Behavior
Estimation from Power Consumption Patterns of
appliances over Smart Tap Network", IEICE
TECHNICAL REPORT, DENSHI JOUHOU
TSUUSHIN GAKKAI, JP, vol. 111, no. 134, 7 July
2011 (2011-07-07), pages 25-30, XP008172279,
ISSN: 0913-5685**

## Description

Technical Field

The present invention relates to a smart tap, such as an electric outlet or a tap for connecting a power plug of one of various electric appliances and household electrical appliances.

Background Art

A currently known system for supplying power to household electrical appliances which is intended for power visualization and reduction in the amount used of power or management of the amount used of power will be illustrated below.

As disclosed in Patent Literature 1, there are publicly known a home energy management system including a power amount measurement unit which measures the amount of presently used power indicating the amount of power presently used in a dwelling unit, an upper limit power amount setting and storage unit capable of setting and storing an upper limit power amount indicating a maximum value for the total amount of power which can be used in the dwelling unit, a power management unit which successively calculates the amount of power presently permitted to be used on the basis of the upper limit power amount and the amount of presently used power that are input, at least one capability control electric appliance which works while adjusting its capability so as to limit power consumption by using the amount of power presently permitted to be used as an upper limit, and a permitted power input unit which successively inputs the amount of power presently permitted to be used to the capability control electric appliance and that the home energy management system includes one or more capability control electric appliances which can each adjust the amount of power to be used by adjusting its operating capability, one or more electric outlet adapters with a current application and interruption control function, and one or more electric appliances which are connected to the electric outlets, and the power management unit performs at least one (one or more) of types of control, instructing the capability control electric appliances to adjust their operating capability and interrupting one or more appliances selected among from the appliances connected to the electric outlets with the interruption function according to a predetermined algorithm.

As disclosed in Patent Literature 1, there is also publicly known the process of, if there are a plurality of capability control electric appliances, determining which one of the capability control electric appliances to operate according to the amount of permitted power and supplying power to the capability control electric appliance or adjusting the operating capability of one of the capability control electric appliances according to the amount of permitted power and occasionally limiting or suspending working of another of the electric appliances.

As disclosed in Patent Literature 2, there is known an electrical quantity monitoring apparatus for monitoring power consumption and the like of an electric appliance connected to a power outlet in a house or a factory. The apparatus is an electrical quantity monitoring apparatus includes a table tap provided with a plurality of power plug sockets which can connect power plugs of a plurality of electric appliances to a power outlet in a house or a factory, a current transformer which individually detects currents flowing through the electric appliances connected to the power outlet via the power plug sockets and a voltage transformer which commonly detects a voltage that are built in the table tap, and a microcomputer which is built in the table tap, monitors electrical quantities, such as the detected currents, the detected voltage, and amounts of power consumption computed on the basis of the currents and voltage, and can control Web transmission of these pieces of monitoring information to a server device of a host system or a general-purpose personal computer over a LAN connection.

As disclosed in Patent Literature 3, there is publicly known an energy saving control system which has a load side to be subjected to energy saving control and an energy saving control side to control an energy-saving state of the load side and in which the load side includes a plug connected to a load and a power tap having a plurality of plug sockets into which the plug is to be inserted, the plug has a built-in IC tag to which load data is written, the power tap includes, for each of the plug sockets, an IC tag reader communicating with an IC tag and obtaining load data and a current detection unit which detects a current supplied to a plug inserted in the plug socket and includes a programmable controller section processing data communicated between the IC tag and the IC tag reader and current detection data from the current detection unit and transmitting the pieces of data to the energy saving control side, and the energy saving control side can perform energy saving control on the basis of the pieces of data obtained through communication with the programmable controller section.

As disclosed in Patent Literature 4, there is publicly known a power supply system including a plurality of power supply connection units serving as slaves which are connected to load appliances and supply power to the load appliances and a display device serving as a master which is connected to the power supply connection units through signal lines and has a display displaying the power use statuses of the power supply connection units by receiving signals transmitted from the power supply connection units. Respective unique addresses are assigned to the power supply connection units, and the power supply connection units are each provided with an address setting section which registers its address in the display device, a current sensing section which senses a current supplied to the power supply connection unit, and a transmission section which transmits a current value sensed by the current sensing section and its address to the display device through the signal line. The display device is provided with a reception section which receives a signal from each power supply connection unit and an arithmetic section which computes the power use status of the power supply connection unit on the basis of the current value sensed by the current sensing section. Power supply to each power supply connection unit is interrupted when the amount accumulated of power exceeds a predetermined threshold value or when the power supply system is used with a current value sensed by the power supply connection unit above a threshold value.

As disclosed in Patent Literature 5, there is publicly known a power supply control apparatus for a power tap having one or a plurality of power plug connection units which includes a standby power detection unit which detects whether the value of supplied power supplied to the one or the plurality of power plug connection units is equivalent to a standby power value and a power supply stop unit which stops power supply to each power plug connection unit when a predetermined time period has elapsed since detection of a value equivalent to the standby power value by the standby power detection unit.

Aside from the systems disclosed in the patent literatures, a so-called smart meter is also known. A smart meter is obtained by making online a conventional energy meter installed in, e.g., every home and is an apparatus for measuring integral power consumption over a fixed time period in one home.

The background-art techniques are all techniques using an electric outlet or a table tap not mounted in a wall, and a measurement instrument and a control device which are necessary are built in the electric outlet or the table tap. When such a built-in device is energized, the device inevitably generates heat due to its resistance.

For example, a criterion for an electric outlet is set such that an upper limit for the temperature of a box outer surface is 85°C. The criterion presents no problem for a simple conventional electric outlet which only supplies power. However, if an electric outlet incorporates various instruments for sensing and control, it is extremely difficult to keep the heating temperature below the reference even when the various instruments energized generate heat, in light of the installation form (wall-mounted installation), i.e., in light of the difficulty of dissipating heat toward outside air. This leads to the need to increase the size of a housing as a mounted portion, i.e., an electric outlet box or to provide a fin, a fan, or the like required to exhaust heat. The size of the electric outlet is limited, depending on the installation form.

If a table tap not mounted in a wall has various built-in instruments for sensing and control, the table tap fundamentally needs to take similar measures to exhaust heat. At the same time, the table tap dissipates heat more easily than a wall-mounted type electric outlet and is not subject to size limitations imposed by wall-mounted installation. Simply increasing the size to exhaust more heat, however, makes the table tap hard to handle.

Additionally, in cases where what electric appliance to connect and use needs to be registered in a system, a registration method may be unknown or there may be no option but to adopt a method using an IC tag, as disclosed in Patent Literature 3. If IC tags are used, only an electric appliance that has an IC tag embedded in a plug can be used, and it is necessary to provide all electric appliances with plugs and embed an IC tag in each plug to perform control in view of the amount used of power across a house.

The techniques disclosed in the patent literatures include one which does not go beyond displaying the amount of power used and a warning based on the amount for an electric appliance connected to a tap or performing control to stop supply of power to the electric appliance and one which performs control to reduce supply of power to an electric appliance if not to stop power. As the tap, a tap including a power measurement unit called a smart tap is adopted.

As one so-called smart grid configuration, a system for automating reduction in the amount consumed of power in each home or the like is being introduced, and measurement and the like of the power consumption in each home or the like are being made online. Meters in the shape of electric outlets are commercialized for the purpose of measuring the amounts of power of household electrical appliances and power sources. The meters are nothing more than on-line watthour meters and merely measure integral power consumption within a fixed time period and transmit a value of the measured integral power consumption. Additionally, the meters measure the amount of power consumption across a house at intervals of several tens of minutes.

Citation List

Patent Literature

Patent Literature 1: Japanese Patent Laid-Open No. 2008-104310
Patent Literature 2: Japanese Patent Laid-Open No. 2008-261826
Patent Literature 3: Japanese Patent Laid-Open No. 2011-010000
Patent Literature 4: Japanese Patent Laid-Open No. 2011-072099

Patent Literature 5: Japanese Patent Laid-Open No. 2011-078177

Summary of Invention

Technical Problem

When energy used by one home, office, building, collective housing, or the like is to be computerized for control purposes, it is necessary not only to measure the power of an individual household electrical appliance and that of a distributed power source and display results of the measurement but also to recognize household electrical appliances through the voltage waveforms and current waveforms of the household electrical appliances and measure and display the statuses of use and the amounts of used power of the household electrical appliances.

More important, it is necessary between household electrical appliances and electric appliances and a supply power source (a system, renewable energy, or a storage battery) to recognize individual household electrical appliances (e.g., which ones of the household electrical appliances and electric appliances are being used in real time) and measure the total power consumption indicating how much power is requested and the amounts of power requested by the individual household electrical appliances as a breakdown of the total power consumption.

A conventional system for power use status and total power consumption visualization requires an ordinary person to perform an activity, such as manually cutting off power to each household electrical appliance or the like or shifting his/her hours of use, with, e.g., conscious patience at the time of power saving. There is a need to carry out power saving and peak cutting while maintaining the quality of life, with as little consciousness of power saving as possible.

Finely controlling in-home power use itself in real time by making use of the computerized status of energy use to learn and recognize an ordinary person's pattern of activity, i.e., the ordinary person's pattern of use of household electrical appliances is sought after. To this end, it is necessary to connect household electrical appliances and perform, for each electric outlet, i.e., the household electrical appliances connected to the electric outlet, measurement of detailed voltage and current waveforms and the like and measurement, collection, computation, control, and communication of the amounts of power and further to perform estimation and control of a power flow on the basis of such pieces of data for one house or a plurality of houses as one unit.

As for supply of power from a supply power source to an individual household electrical appliance, it is possible to interrupt power and reduce supplied power according to predetermined priority ranking, in order to control power use in a home.

However, in a standard home, the amount of the maximum power of a household electrical appliance is 1.5 kW. That is, a maximum current that is 15A at most in Japan and is 7.5 A (200 V) abroad is supplied, which causes a large current to flow through a power control device built in an electric outlet. There is fear that the power control switching device generates heat.

Additionally, if an electric outlet provided with the above-described function is a wall-mounted type one which is mounted in a wall of a building, such as a house, the electric outlet needs to include a current measurement unit, a voltage measurement unit, a measurement unit, a computation and control unit, a communication unit for origination and reception, a current control unit, a voltage control unit, and the like. In this case, these units, particularly a power control and switching on/off unit, generate heat. Unless a power flow (a flow of power) is reduced, too large amount of heat generation raises the whole electric outlet to a high temperature to lower safety, and the devices as the units described above forming the electric outlet may degrade or malfunction.

Since if a power plug of an electric appliance which consumes high power, such as an air conditioner or a microwave oven, is connected to one electric outlet, a power flow may increase to overheat the electric outlet, a current of 15A cannot be supplied to an electric appliance.

There is concern that confinement of heat due to the overheating not only simply lowers safety but also deteriorates the device stability. Although an upper limit temperature as a criterion for the temperature of an outer surface of an electric outlet box in use that is based on the provisions of Electrical Appliances and Material Safety Act is 85°C, and the outer surface needs to be kept at or below 85°C, the provisions may not be satisfied.

Simply satisfying the provisions, however, is not sufficient. Even when the provisions are satisfied, the temperature inside an electric outlet box is higher than that of its outer surface and is not less than 85°C. Even with such a rise in temperature, a component housed in the electric outlet needs to be kept at or below 80°C in order to prevent a power waveform and a microcomputer chip for measurement control from deteriorating. Additionally, it is more difficult to select and use a component weaker against heat, such as a crystal oscillator, which decreases in life as a communication unit oscillator having a communication function at a temperature above, for example, 80°C. There is a need to stably use such a component weak against heat.

For this reason, as a way to prevent overheating, installing a fan or constructing a whole mounted type electrical outlet of a metal, such as aluminum, to promote heat dissipation is conceivable. However, the installation of the fan increases the size of the electric outlet, and a place where the electric outlet can be installed is limited in view of the mounted type. The idea of constructing the whole electric outlet box of a metal, such as aluminum or copper, and providing the metal plate with the capacity to dissipate heat generated inside the electric outlet is also conceivable. The metal, however, blocks radio waves to interrupt wireless communication with the outside.

A table tap including a current measurement unit, a voltage measurement unit, a timing unit, a computation and control unit, a communication unit for origination and reception, a current control unit, a voltage control unit, and the like may be adopted, instead of a mounted type electric outlet. In this case, forcible connection of such table taps to all electric appliances including a light mounted in a ceiling or a wall, and the like is necessary. The adoption of table taps is unrealistic.

An Energy on Demand, i.e., EoD (hereinafter referred to as "EoD") system needs to supply one or more power sources including a commercial power source to one unit described above and determine from which one of the plurality of power sources supplied to the one unit power is supplied and how much power is supplied. Thus, the EoD system has as its objectives to identify a household electrical appliance connected by a power plug on the basis of, e.g., a result of measuring the power waveforms of a plurality of electric appliances at the time of energization of the electric appliances, to grasp the operation statuses of the electric appliances and detect abnormal operation to control the EoD system or to take measures to, e.g., set an operation-related priority for each household electrical appliance during operation or at the start of operation and optionally use a household electrical appliance with high priority with a simpler apparatus, and to smoothly perform communication and reduce the number of control devices to be used.

Solution to Problem

With a view to, for example, controlling the amounts of power used by household electrical appliances in a house on the basis of an overall power use status such that operation of all household electrical appliances is within a range allowing a more smooth life while setting the priorities for use of household electrical appliances, through estimation and control of a power flow itself consumed by and circulating through one or a plurality of power sources, a power network for the power sources, and household electrical appliances on the power network, the present invention adopts the one below among smart taps which are taps including a power measurement unit.

Between household electrical appliances and electric appliances and supply power sources (a system, renewable energy, and a storage battery), a real-time request packet indicating which household electrical appliance requires power and how much power is required is transmitted to a server, and the server determines (performs arbitration about) the amount of suppliable power on the power source side and then transmits a packet indicating suppliable power to the household electrical appliance side. That is, after two-way packet transmission as a result of determination of (arbitration about) the balance between request and supply, supply of power to a household electrical appliance or an electric appliance is started. This is a power control system based on an EoD system.

A smart tap of the present invention can fulfill, in the EoD system, the following functions 1) to 8): 1) a communication function, such as origination and reception; 2) a function of calculating power consumption; 3) a function of recognizing household electrical appliances and electric appliances by collation with current and voltage waveforms of household electrical appliances and electric appliances registered in a server; 4) a function of making a notification of detection of an abnormality (an abnormality such as an electric leak) in each electric appliance by comparing a normal power waveform pattern with an actually measured waveform as an extension of the function of recognizing current and voltage waveforms of household electrical appliances and electric appliances; 5) a function of power control, switch-on/off, remote control, and the like; 6) a sleep function for reducing the power consumption of the smart tap itself when a connected household electrical appliance is not used and a wake-up function; 7) a function for safety against an abnormal current and an abnormal voltage from home appliances and power sources; and 8) a function of sensing an environment (e.g., temperature and humidity).

With use of the smart tap supporting the EoD system, in the case of, for example, a home, an ordinary person's pattern of activity is learned, the priorities of household electrical appliances and electric appliances are automatically recognized, and a power use model is built. A power use plan is created from the power use model, and measurement and calculation of an instantaneous upper limit value are performed in real time by power peak cutting and power upper limit value setting, thereby allowing peak cutting at the time of accumulation and power control that prevents a set upper limit value from being exceeded. Requests from household electrical appliances are received in real time, and power saving and peak cutting is performed such that power is saved as little as possible for household electrical appliances and electric appliances with higher priorities and such that power saving and peak cutting are performed mainly on household electrical appliances with lower priorities, by automatic or manual setting of priorities. Thus, power saving and peak cutting, particularly peak cutting at the time of accumulation, can be implemented without impairing the comfort of an ordinary person (a condition without the need to tolerate power saving).

Specific examples of the smart tap are as described below.

1. A smart tap into which one or more than one power plugs can be inserted, comprising a voltage waveform measurement unit, a current waveform measurement unit, a communication unit, a control unit, and an arithmetic unit, wherein the voltage waveform measurement unit and the current waveform measurement unit are units which measure a voltage waveform and a current waveform of power supplied to each of one or more home appliances via a corresponding one of respective power plugs connected to the home appliances, the communication unit is a unit which transmits the voltage waveform and the current waveform or a result of processing of the waveforms to a server which is installed in a place separate from the smart tap and receives a control signal based on a result of computation in the server, and the control unit is a unit which controls switching of the power supplied to the home appliance and the amount of the supplied power in accordance with the control signal.

2. The smart tap according to 1, wherein the control unit has a function of controlling the amount of the power supplied to each of the home appliances with the power plugs connected to the smart tap on the basis of data on the amount of suppliable power received from the server, and the smart tap further comprises a sensing unit which analyzes the waveforms obtained from the voltage waveform measurement unit and the current waveform measurement unit and recognizes a status of and senses an abnormality in each home appliance and a sensing and communication unit for transmitting a sensing result from a sensor which is installed in a building to the server.

3. The smart tap according to 1 or 2, for being supplied by a plurality of power sources.

4. The smart tap according to 1 or 2, wherein the smart tap comprises a mounted type electric outlet which is mounted in a wall portion, a ceiling portion, a floor portion, or the like of a house or a tap which is connected to a mounted type electric outlet or a tap.

5. The smart tap according to 3, wherein the smart tap is installed in a facility into which a single power source or a plurality of power sources selected from among a plurality of power sources including system power, photovoltaic power generation (PV), wind power generation, small hydropower generation, a fuel cell, and a storage battery are led.

6. A smart tap into which one or more than one power plugs can be inserted,
wherein the smart tap comprises a voltage waveform measurement unit, a current waveform measurement unit, a current measurement unit and a voltage measurement unit for measuring the amount of power consumption, an arithmetic unit, and a communication unit,
the voltage waveform measurement unit and the current waveform measurement unit are units which measure a voltage waveform and a current waveform of power supplied to each of one or more household electrical appliances via a corresponding one of respective power plugs connected to the household electrical appliances,
the current measurement unit and the voltage measurement unit measure a current and a voltage supplied to each household electrical appliance,
the arithmetic unit is a unit which obtains the amount of power consumption from a current value and a voltage value obtained through measurement in the current measurement unit and the voltage measurement unit, and
the communication unit is a unit which transmits the voltage waveform, the current waveform, and/or the measured and calculated amount of power consumption of each household electrical appliance to a server which is installed in a place separate from the smart tap and receives a control signal based on a result of computation in the server.

7. The smart tap according to 6, wherein the smart tap is provided with a household electrical appliance remote control function for a household electrical appliance having a remotely-controlled power control function and is capable of adjusting the amount of power supply to a household electrical appliance and turning on/off power to the household electrical appliance via the household electrical appliance remote control function in response to a demand for power reduction from the server.

8. The smart tap according to 6 or 7, for being supplied by a plurality of power sources.

9. The smart tap according to 6 or 7, wherein the smart tap comprises a mounted type electric outlet which is mounted in a wall portion, a ceiling portion, a floor portion, or the like of a house or a tap which is connected to a mounted type electric outlet or a tap.

10. The smart tap according to 8, wherein the smart tap is installed in a facility into which a single power source or a plurality of power sources selected from among a plurality of power sources including system power, photovoltaic power generation (PV), wind power generation, small hydropower generation, a fuel cell, and a storage battery are led.

11. A smart tap into which one or more than one power plugs can be inserted,
wherein the smart tap comprises a voltage waveform measurement unit, a current waveform measurement unit, a current measurement unit and a voltage measurement unit for measuring the amount of power consumption, an arithmetic unit, a communication unit, and a control unit,
the voltage waveform measurement unit and the current waveform measurement unit are units which measure a voltage waveform and a current waveform of power supplied to each of one or more household electrical appliances via a corresponding one of respective power plugs connected to the household electrical appliances,
the current measurement unit and the voltage measurement unit measure a current and a voltage supplied to each household electrical appliance,
the arithmetic unit is a unit which obtains the amount of power consumption from a current value and a voltage value obtained through measurement in the current measurement unit and the voltage measurement unit,

the communication unit is a unit which transmits the voltage waveform, the current waveform, and/or the measured and calculated amount of power consumption of each household electrical appliance to a server which is installed in a place separate from the smart tap and receives a control signal based on a result of computation in the server, and the control unit is a unit which controls the amount of supplied power supplied to the household electrical appliance in accordance with the control signal.

12. The smart tap according to 11, wherein
the control unit has a function of controlling the amount of power supplied to each of the household electrical appliances with the power plugs connected to the smart tap on the basis of data on the amount of suppliable power received from the server,
the smart tap further comprises a sensing unit which analyzes the waveforms obtained from the voltage waveform measurement unit and the current waveform measurement unit and recognizes a status of and senses an abnormality in each household electrical appliance, and
the communication unit has a function of receiving a sensing result from a sensor which is installed in a building and/or a control signal from a household electrical appliance and transmitting the sensing result and/or the control signal to the server.

13. The smart tap according to 11 or 12, wherein the smart tap is provided with a household electrical appliance remote control function for a household electrical appliance having a remotely-controlled power control function and is capable of adjusting the amount of power supply to a household electrical appliance and turning on/off power to the household electrical appliance via the household electrical appliance remote control function in response to a demand for power reduction from the server.

14. The smart tap according to 11, wherein the control unit includes a semiconductor relay, a mechanical relay, or a semiconductor device.

15. The smart tap according to 14, wherein the communication unit is installed on the reverse of a panel made of a non-metal material at a front on the plug socket side of the smart tap, and a heating section of the control unit is fixed to a housing with an insulating heat-transfer member for heat dissipation between the heating section and the housing.

16. The smart tap according to 14 or 15, wherein the control unit includes a MOSFET.

17. The smart tap according to 16, wherein the amount of heat generation of the MOSFET is not more than 8 W.

18. The smart tap according to 17, wherein the amount of heat generation of the MOSFET is not more than 1 W.

19. The smart tap according to 11 or 12, for being supplied by a plurality of power sources.

20. The smart tap according to 11 or 12, wherein the smart tap comprises a mounted type electric outlet which is mounted in a wall portion, a ceiling portion, a floor portion, or the like of a house or a tap which is connected to a mounted type electric outlet or a tap.

21. The smart tap according to 19, wherein the smart tap is installed in a facility into which a single power source or a plurality of power sources selected from among a plurality of power sources including system power, photovoltaic power generation (PV), wind power generation, small hydropower generation, a fuel cell, and a storage battery are led.

Advantageous Effects of Invention

Since the priorities of household electrical appliances can be changed according to a user's status of use of the household electrical appliances, the user can use a required electrical appliance when necessary.

A smart tap of the present invention can control power supply according to, e.g., a power use pattern associated with a user's usage which is set in advance. The user of a household electrical appliance can use electricity in the power use pattern set in advance without particular inconvenience. Additionally, since the priorities for use of available household electrical appliances are changed by the power consumption of a household electrical appliance powered on by the user, power supply can be controlled in real time.

The smart tap of the present invention is a system which can automatically perform control so as to meet a demand for power reduction from the supply side without fail and can thus guarantee a rate of power reduction on the demand side in response to a demand from the supply side while using necessary household electrical appliances without requiring additional labor.

Introduction of a power arbitration unit which guarantees an upper limit for used power allows provision of a guarantee of a power saving rate and a peak reduction rate. For this reason, an on-demand power control system can be implemented instead of a conventional HEMS.

Reduction in the amount of heat generation of a mounted type smart tap has eliminated the need to construct the whole surface of a box of the smart tap of a metal, such as aluminum, which has high thermal conductivity and promises a heat dissipation effect. In a smart tap mounted in, e.g., a wall of a building, a metal heat dissipation plate is not installed at an outer portion of a resin housing, and radio waves can pass through a tap box. Thus, radio waves from a communication unit are not blocked, and the communication unit installed inside the electric outlet box can communicate with the outside.

Even if a power plug of a household electrical appliance requiring a larger power flow is connected to a smart tap, a power control device has low resistance, and the smart tap is not overheated by such units. Thus, a component using a crystal oscillator weak against heat and the like can be installed in an electric outlet, and power supply control can be performed for a household electrical appliance requiring such a large power flow. If power is supplied to all household electrical appliances and electric appliances in a building via such smart taps, power sources connected to power plugs of the household electrical appliances and electric appliances can perform operation control of the appliances.

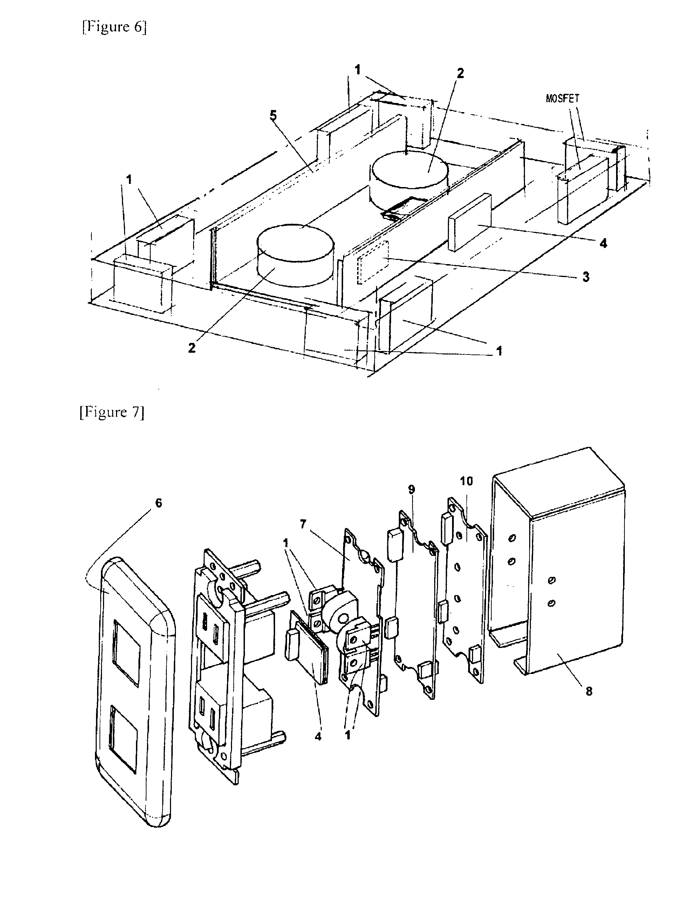

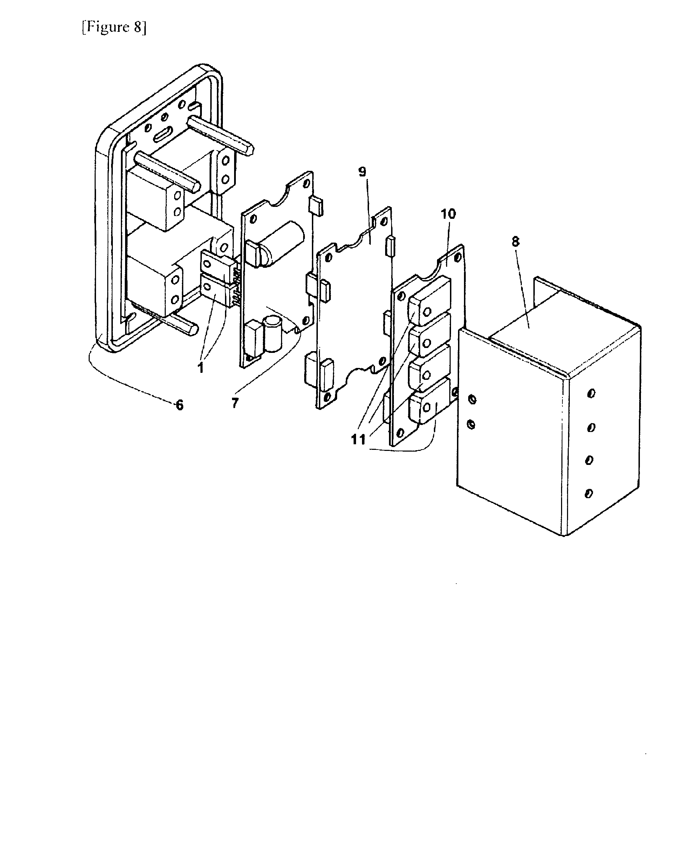

Note that since there is no metal component above a communication unit in a smart tap structure (Figures 7 and 8) which improves the communication performance of the communication unit of a mounted type smart tap, communication interruption does not occur, and the communication performance can be improved. Thus, in the smart tap structure in Figures 7 and 8, a housing at a back on the side opposite to the obverse side where a plug is to be inserted can be changed to a metal housing with high heat dissipation. By dissipating heat from a MOSFET that is the cause of heat generation to the metal housing via an insulating heat dissipation member, the temperature inside a tap can be kept at or below 80°C or 70°C. This allows use of a MOSFET other than a MOSFET which generates a small amount of heat, i.e., has low on resistance.

For this reason, a communication unit which measures power and transmits current and voltage waveforms is provided on the reverse of a panel made of a resin material at a front on the plug socket side of a smart tap. In this case, since a portion around a reception section of the communication device is made of a non-metal material, the communication performance is not lowered. A heating section of a power control device section is installed behind the communication device.

The temperature inside the smart tap and the temperature of a metal housing can be kept at or below 80°C by dissipating heat to the housing or a metallic heat sink via a heat dissipation member (a sheet or an adhesive sheet) with, e.g., insulation property. That is, heat generation can be suppressed without impairing the communication performance of the tap, and an inexpensive device can be used instead of a power control device with low on resistance, without reducing the life of each device in the tap.

If a smart tap is structured such that a communication unit is provided on the reverse of a non-metal resin which does not lower the communication performance and such that a power control device is installed behind the communication unit, it is also possible to use a housing of a highly thermal conductive resin composite material which is highly thermal and conductive and has insulation property and interpose an insulating heat dissipation member between a heating section and the insulating highly thermal conductive resin housing.

This allows reduction in heat generation without impairing communication performance and allows use of an inexpensive control device.

As described above, a communication device can be installed inside a smart tap, particularly at a portion of, e.g., metal which suffers little communication interruption. For example, in a structure with a communication device provided at a side, a resin housing suffering little communication interruption is used. The amount of heat generation can be kept at or below 80°C by selecting a device which generates a small amount of heat, i.e., has a small on resistance value as a power control device.

As a result, the amount used of power of all household electrical appliances in a building for a fixed period can be effectively reduced by performing operation control of, in particular, a household electrical appliance requiring a large power flow.

Use of a smart tap of the present invention allows peak cutting on power used by an arbitrary household electrical appliance, reduction in the amount of power supplied to an arbitrary household electrical appliance, shifting of hours of operation for an arbitrary household electrical appliance, and the like while sensing the amount used of power across a house, without forcibly connect table taps to all household electrical appliances including household electrical appliances mounted in walls and ceilings, such as a light.

In response to an upper limit power value and a peak-cut power value in a demand from a server, the smart tap can perform (1) interruption of power to and (2) adjustment of the amount of power to each household electrical appliance so as to prevent the power values from being exceeded, by means of a semiconductor device. Additionally, equipment of an infrared ray remote control function allows switch-on/off and adjustment of reduction in power.

Note that a semiconductor relay (SSR: Solid State Relay), a mechanical relay, or a semiconductor device (a triac or a MOSFET (metal oxide semiconductor field effect transistor)) can be used as a power amount adjustment unit with which the electric outlet is equipped. In order to perform control so as to prevent a peak-cut power value from being exceeded, a mechanical or semiconductor relay may be provided to perform on/off control. Such a mechanical relay, however, has the property of low response speed.

The low response speed may lead to a situation in which if the amount of power requested by a household electrical appliance increases rapidly before a response is completed, power amount control cannot catch up with the increase, and the peak-cut power value is exceeded. In order to guarantee the fact that the peak-cut power value is not exceeded even with a delay in response time for prevention of occurrence of the situation, a margin for the amount of power needs to be set to be large. For example, control, such as setting an upper limit value to 70 to 80 W with respect to an upper limit of 100 W, needs to be performed. However, a mechanical relay can be effectively used for a household electrical appliance which tolerates a delay in response time.

Thus, a semiconductor device with a high response speed for the smart tap is preferably used. The use allows adjustment that prevents an upper limit value for power from being exceeded through setting of a small margin. The adjustment that prevents the upper limit value from being exceeded is easier to guarantee. The feature of an EoD system is to guarantee peak cutting at the time of accumulation by real-time handling of instantaneous peak power with respect to a life use plan for power. For a switching function, such as switching between on and off, and power control, a fast-response semiconductor, a semiconductor relay, and a mechanical relay are preferable in this order. In terms of size, a semiconductor device is more preferable.

Brief Description of Drawings

[Figure 1] Figure 1 shows voltage and current waveforms of a hair dryer and a cleaner.

[Figure 2] Figure 2 is a view of installation of mounted type electric outlets and a tap for an on-demand power control system in a building.

[Figure 3a] Figure 3a shows a result of control according to the present invention, as seen from the transition of power consumption.

[Figure 3b] Figure 3b shows a result of control according to the present invention, as seen from the transition of power consumption.

[Figure 4] Figure 4 is a schematic view showing the configuration of a smart tap according to the present invention.

[Figure 5] Figure 5 is a view showing a situation where the present invention is carried out when a plurality of power sources are used.

[Figure 6] Figure 6 is a view of a layout of units according to the present invention.

[Figure 7] Figure 7 is a view of a different layout of the units of the present invention.

[Figure 8] Figure 8 is a view of the different layout of the units of the present invention.

[Figure 9] Figure 9 is a chart showing a graph of instantaneous power obtained when a power use plan reduced by 10% and 30% is used.

[Figure 10] Figure 10 is a chart showing a graph of instantaneous power obtained when the power use plan reduced by 10% and 30% is used.

[Figure 11] Figure 11 is a chart showing a graph of integral power consumption obtained when the power use plan reduced by 10% and 30% is used.

[Figure 12] Figure 12 is a chart showing a graph of integral power consumption when the power use plan reduced by 10% and 30% is used.

Reference Signs List

1　MOSFET
2　current measurement unit
3　arithmetic unit
4　communication unit
5　circuit board for arithmetic unit power source
6　front
7　board
8　housing
9　board
10　board
11　control device

Description of Embodiment

A smart tap according to the present invention can be used exclusively for an on-demand power control system (EoD system) in a home network. The system is an on-demand power control system which has an upper limit value within a fixed period or at an instant for the amount of used power that is set in advance and performs control to supply power to household electrical appliances and electric appliances (hereinafter collectively referred to as "household electrical appliances") beginning with an important one with high priority for a user without impairing a user's quality of life while controlling the demand side within a range not exceeding the upper limit value and is used together with a home server (hereinafter referred to as the "server") separately installed as described above.

The system aims to make a 180-degree shift from a power-supplier-centric "push" (or demand response) power network to a power-demander-driven (e.g., user- or consumer-driven) "pull" (on-demand) power network. The system is particularly suitable as a system in which a server infers "which one of requests from household electrical appliances is most important" from a user's usage pattern in response to requests for power from various household electrical appliances (e.g., requests from an air conditioner and a light) in one home or two or more homes and performs control (hereinafter referred to as "household electrical appliance dynamic priority control" so as to supply power to household electrical appliances beginning with an important one with high priority.

The biggest change brought about through use of the EoD system is that energy saving and $CO_2$ emissions reduction can be performed from the demand side. The system is a system in which, for example, if a user sets instructions to cut an electric cost for a fixed period or the amount of power for a fixed period by 20% in a server in advance, household electrical appliance dynamic priority control can make a user-centric effort to feed only power cut by 20% to implement energy saving and $CO_2$ emissions reduction.

Additionally, the priorities of household electrical appliances can be arbitrarily set by a user or can be set by a preset program according to the season, weather, temperature, humidity, time, and the like. In addition, the EoD system can automatically determine, as needed, to which household electrical appliance power is preferentially supplied on the basis of a plan and an upper limit for power to be supplied and supply power based on the priorities of household electrical appliances to each household electrical appliance on the basis of a result of the determination.

It is also possible to build a power use model by learning an ordinary person's pattern of activity, in addition to the plan and the upper limit for power to be supplied, and determine the priorities of household electrical appliances according to the model.

In these cases, the EoD system can be made into a control system which can build a power use model on the basis of a plan and an upper limit for power supply, an ordinary person's pattern of life, and the ordinary person's pattern of life obtained through learning and set a power use plan and in which an accumulated peak power value is not exceeded during real-time measurement comparison and calculation of an instantaneous peak power value with respect to the power use plan.

The above-described EoD system is based on measuring the amount of real-time power required by each household electrical appliance (requested by the household electrical appliance), i.e., the amount of requested power from voltage waveforms, current waveforms, voltage values, and the amounts of currents of power supplied to household electrical appliances connected to an electric outlet or a tap inside the electric outlet or the tap. The measurement is performed at the extremely high sampling rate described below. A result of the measurement is subjected to computation in an arithmetic unit inside the electric outlet or the tap and is recognized and analyzed as patterns of voltage waveforms and current waveforms.

Voltage waveforms and current waveforms of power supplied to household electrical appliances often have different patterns among the household electrical appliances. That is, a household electrical appliance presently incorporates a control device such as a switching power source or an inverter, and a waveform characteristic of each household electrical appliance appears in a current waveform within one AC cycle. For this reason, even if household electrical appliances consume the same power, the household electrical appliances are often different in voltage and current waveforms. Compilation of patterns of voltage and current waveforms as described above into a database on a server or the like makes it possible to identify what a household electrical appliance connected to an electric outlet or a tap is and sense the operation status of each household electrical appliance, occurrence of a problem, and the like.

Results of recognition and analysis in smart taps are transmitted to a server. The server makes a determination on the basis of the operation statuses of household electrical appliances, i.e., which home appliance is in operation and which home appliance is powered on, the amount of requested power, the amount or suppliable power, the priorities of the electric appliances, and the like and transmits signals for controlling the amounts of power supplied to individual household electrical appliances to the smart taps, as needed. The transmission can be performed through, e.g., packet communication.

Each smart tap receives a packet and controls supply of power to connected household electrical appliances in accordance with an instruction in the packet. For this reason, a household electrical appliance immediately after being powered on can be kept in a standby state until an instruction for power supply is received, instead of being made to start operation. It is also possible to turn off a household electrical appliance in operation or reduce or increase power to be supplied.

The present invention will be described below.

A smart tap according to the present invention is a smart tap, such as a so-called table tap. The smart tap is an apparatus which can supply power to a household electrical appliance when a power plug of the household electrical appliance is directly connected. The apparatus may be an apparatus used connected to an electric outlet mounted in, e.g., a wall surface of a building or may be a mounted type electric outlet mounted in a structure or equipment, such as a wall surface, a column, a ceiling, a floor, or furniture of a building. Such smart taps may have one socket, two sockets, or three or more sockets and are not particularly limited in shape. Household electrical appliances connected to the electric outlet or the tap include so-called household electrical appliances used in a home or a collective housing and electric appliances and the like installed in, e.g., an office building, a multi-tenant facility, a hospital, or a place of business.

A conventional so-called table tap having two or more sockets, a tap for bifurcating an electric outlet, or the like may be connected to a smart tap of the present invention, and a plurality of household electrical appliances may be connected to the table tap. In that case as well, the smart tap can individually sense and control the plurality of connected household electrical appliances via the smart tap, to which the electric appliances are directly connected.

It is also possible to further connect a smart tap having two or more sockets of the present invention to a smart tap of the present invention. In this case, both the smart taps can be made to function or either one can be made to function.

A voltage waveform measurement unit usable in a mounted type smart tap according to the present invention may be a publicly known measurement unit for control that measures a real-time voltage waveform. Any general-purpose measurement unit can be adopted as long as the measurement unit is sized so as to be housed in a mounted type smart tap, like a current waveform measurement unit.

A current measurement unit for current waveform measurement and power consumption measurement usable in a mounted type smart tap according to the present invention may be a publicly known measurement unit for control that measures a real-time current waveform. A general-purpose measurement unit, such as a CT, a shunt, or a Rogowski coil, can be adopted as long as the measurement unit is sized to as to be housed in a mounted type smart tap.

A unit for obtaining the amount of power is a unit for obtaining the amount of power on the basis of measurement values of a measured current and a measured voltage.

A communication unit according to the present invention is basically a unit capable of, between the communication unit and a server installed in a different place in a home, transmitting various types of data in an EoD system (to be described later), such as a voltage waveform, a current waveform, data obtained through processing of the waveforms, the attribute of a household electrical appliance whose power plug is connected and the amount of power consumption of the household electrical appliance calculated in an arithmetic unit, and a request power message when a household electrical appliance is turned on, to the server and receiving data required to control a household electrical appliance which is obtained through arbitration in the server, i.e., a power assignment message to a household electrical appliance powered on and requesting power supply which is a result of computing, for the household electrical appliance, the priorities for supply of power to and the amounts of requested power of household electrical appliances including other running household electrical appliances, and the like.

Communication of the communication unit may be performed through packet communication and is performed with arbitrary timing.

The communication unit can include an oscillating circuit, such as a crystal oscillator.

For the communication unit, a ZigBee module (e.g., 2.4 GHz or 920 MHz) can be adopted. Any other publicly known wireless communication unit (e.g., Z-Wave, Bluetooth (registered trademark), DECT (1.9 GHz band), or UHF (950 MHz band)) can also be adopted.

PLC or the like can be used as a wired communication unit besides the wireless communication units.

If the communication unit conforms to the ZigBee standard, the communication unit has a low communication speed. However, the communication unit can be made to function as a repeater for a different smart tap by making use of a network relay function of, e.g., the mesh type or the star type as the feature of the standard. For this reason, the communication unit can flexibly expand a network and can reliably transmit and receive data to and from the server due to its ability to repair a communication path failure caused by a malfunction. Additionally, since the communication unit consumes extremely low power, the communication unit has the advantage in that the total power consumption is extremely low even when smart taps with the communication units are installed at all electric outlets in a building.

Particularly when a wireless communication unit is adopted as a communication unit in a smart tap of the present invention, the communication unit is preferably arranged inside a panel made of a material which does not block radio waves, such as resin, at a front of the smart tap aligned with an electric outlet. In the case of a smart tap mounted in, e.g., a wall, a front of the smart tap faces toward the interior of a room. Communication data originating from a wireless communication unit of the smart tap is directly directed toward the interior of the room, which enhances reachability to a server or the like. The wireless communication unit directed toward the interior of the room can more reliably receive a signal originating from the server or the like.

A control unit according to the present invention is a unit which receives a control signal based on a result of computation in a server and controls the amount of power supplied to each household electrical appliance via processing in an arithmetic unit and by extension is a unit which controls switching of power supplied to a household electrical appliance and the amount of supplied power. Note that the switching refers to stopping or starting supply of power to a household electrical appliance. In the present invention, a semiconductor relay, particularly a MOSFET which performs phase control and the like, is used. A power flow to be supplied varies according to a connected household electrical appliance. Since the commercial power is AC power, four to about eight semiconductor devices (at least one or two or more per socket, to which a power plug is to be connected, of an electric outlet or a tap) can be provided, depending on the on resistance value of each semiconductor device itself. The maximum power consumption of a commonly used domestic household electrical appliance is up to 1500 W, and the voltage of a general electric outlet is 100 V in Japan. In view of the fact that a current of up to 15A flows through one electric outlet, the amount of heat generation of the control unit is considered in the manner below. Note that a current of up to 7.5 A is supplied to a 200V electric outlet in Japan and to an electric outlet in a country or a region other than Japan where the voltage of an electric outlet is, for example, 200 V.

As a semiconductor device, a triac, a MOSFET, a non-zero cross type unit, such as an SSR (solid state relay), or the like can be used.

In particular, a MOSFET consumes low power for controlling the amount of power and generates a small amount of heat. A MOSFET is preferable to a triac in terms of the amount of heat generation. A triac has an on resistance of 0.1 $\Omega$ and generates heat of 23.25 W under the conditions of 15A and 1.5 kW. For example, if a MOSFET has an on resistance of 0.038 $\Omega$, the MOSFET generates heat of 2.1 W, which is obviously lower.

For a MOSFET, Si, SiC, GaN, or the like can be used. A MOSFET with low on resistance is desirable.

Control operations by the above-described semiconductor devices have the common advantage of high response speed. If as high response speed as possible is required when power supplied to a household electrical appliance is controlled, a semiconductor device is extremely effective. On the other hand, if high response speed is not required, a semiconductor relay or a mechanical relay can also be adopted as the control unit. An example of this case is a case where there is much time to control other household electrical appliances. For example, if a household electrical appliance, to which power needs to be newly supplied, is a household electrical appliance which does not require much power for a predetermined time period after the start of operation, a mechanical relay uses the predetermined time period to control supply of power to another household electrical appliance by a mechanical relay. When a mechanical relay is used, the mechanical relay generates a small amount of heat at the time of control is small, like a MOSFET, and has a small thermal effect on an arithmetic unit and a communication unit.

An arithmetic unit according to the present invention is a microcontroller or the like. The arithmetic unit is an arithmetic unit which recognizes what a household electrical appliance connected to an electric outlet is on the basis of a current waveform obtained from a current waveform measurement unit and a voltage waveform measurement unit and is also an arithmetic unit for sending a current waveform and a voltage waveform and the name of a connected household electrical appliance to a server. Note that the arithmetic unit is also an arithmetic unit which calculates the amount of effective power, i.e., the amount of power consumption and the amount of requested power from an effective current and an effective voltage obtained through current waveform measurement and voltage waveform measurement.

The process of recognizing what a household electrical appliance connected to an electric outlet is can be performed at a point in time before the household electrical appliance is turned on (e.g., when the household electrical appliance is connected to the electric outlet). Alternatively, what the household electrical appliance is may be recognized only after the household electrical appliance is connected to the electric outlet and then turned on.

At this time, a power waveform is measured in a smart tap from after a lapse of 0.1 or 0.5 sec since the connected household electrical appliance is turned on to after a lapse of 2 sec and is transmitted to a server. The power waveform is checked against power waveforms registered in advance in the server, which allows identification of the turned-on household electrical appliance.

After that, power may be supplied to the household electrical appliance. Alternatively, the household electrical appliance may be temporarily placed in an off state, power to be supplied may be computed in the server, the data may be transmitted to the smart tap, and supply of power or suspension of supply of power to the household electrical appliance may be carried out.

Note that if recognition of a household electrical appliance is performed when the household electrical appliance is connected to an electric outlet, smart tap control can be extremely speedily performed when the household electrical appliance is turned on after the connection and that on the other hand, if a connected household electrical appliance is recognized when the household electrical appliance is turned on, it takes a small amount of time before the household electrical appliance is controlled after the household electrical appliance is turned on.

A function is also provided of sending a computed signal to a MOSFET or the like that controls supply of power to an electric outlet, to which a household electrical appliance is connected, on the basis of a voltage control signal and a current control signal as a supply message obtained from a server via a communication unit.

Note that a server is configured to perform arbitration computation using the amounts of requested power of respective household electrical appliances and power suppliable from a single or a plurality of power sources and control supply of power to the household electrical appliances on the basis of the priorities of the household electrical appliances to thereby perform power saving and peak cutting for each house or the like. The server can stop or suspend operation of a household electrical appliance in operation, reduce power supplied to the household electrical appliance, or increase the supplied power.

As a result, it is possible to make a response to a household electrical appliance freshly powered on by supplying power requested by the household electrical appliance, supplying only part of the requested power, or keeping the household electrical appliance waiting for the start of operation without supplying the requested power until later control timing.

The ambient temperature of a microcontroller is preferably not more than 80°C in terms of the lives of smart tap components. The amount of heat generation of a MOSFET is preferably not more than 8 W in terms of the life of a communication unit.

If a communication unit is installed on the reverse side of a panel made of a non-metallic material, such as resin, at a front on the plug socket side which is free from communication interruption, a heating section of a MOSFET can dissipate heat to a metal housing (of, e.g., Al), a metal heat sink, or the like at a back on the side opposite to the front of the electric outlet via an insulating heat dissipation material, heat dissipation sheet, or heat dissipation adhesive sheet. On the other hand, if an electric outlet front member made of a metal member prone to communication interruption is adopted, a housing made of a non-metal, such as resin, is selected to curb reduction in communication performance because a communication unit is built in a smart tap. Since the non-metallic housing provides poorer heat dissipation than the above-described metal housing, the amount of heat generation of the MOSFET is preferably not more than 1 W.

That is, a parallel connection structure in which a current supplied to each MOSFET is reduced or a series connection structure (i.e., two power control devices for one socket) in which a supplied power is not reduced can be adopted such that heat generated by power control devices can be kept at or below 80°C in terms of the product life and safety of a smart tap.

Additionally, a radiator plate which does not affect a communication unit can be provided not in a smart tap housing itself but inside mounted devices. Alternatively, in view of heat dissipation of a housing of a smart tap which is made of metal, as will be described below, a power control device can be connected to the housing via an insulating heat dissipation sheet.

Particularly if a communication unit is arranged on the inner side of a panel at a front of a smart tap made of a material (e.g., resin) through which radio waves can pass, as described above, the communication unit can perform communication by radio waves passing through the panel. Thus, a housing of the smart tap can be made of a metal through which radio waves do not pass.

In this case, since the metallic housing also acts as a radiator plate, a control unit, such as an FET, can be connected to the housing via a publicly known material for heat dissipation, such as an insulating heat dissipation sheet (e.g., 0.5 to 20 W/mK). As a result, heat generated by the control unit can be dissipated from the housing to the surroundings through the insulating heat dissipation sheet. In this case, a fin for heat dissipation or the like can also be provided outside the housing. Note that a resin made of a highly thermal conductive resin composite, such as BN or ALN with insulation property, can be used as a housing instead of a metal housing.

For this reason, even if the amount of heat generation of one control unit is about 8 W, since heat is dissipated from the housing to outside the smart tap, the communication unit can be prevented from rising in temperature.

A sensing unit which recognizes the status of a household electrical appliance and senses an abnormality (e.g., a malfunction or an electric leak) may double as the arithmetic unit described above. The sensing unit can be provided separately from an arithmetic unit and a control unit. In that case, the sensing unit is a unit which, when a voltage waveform and/or a current waveform computed in the arithmetic unit exhibits some abnormality, and data indicated by a signal from a server also exhibits an abnormality, senses an abnormality by making a comparison with the normal state of a household electrical appliance. The sensing unit may be capable of indicating the presence or absence of an abnormality in the form of sound or light, as needed, when an abnormality is found from the status of a household electrical appliance as a result of sensing.

During normal operation, the amount of power consumption controlled with use of a smart tap and the operation status of each household electrical appliance are displayed on a display utilized for power visualization (e.g., a TV, a PC, a monitor, a mobile device (a smartphone or a tablet PC)). Upon occurrence of an abnormality, the occurrence of the abnormality can also be displayed on the display to inform a user of the occurrence.

The household electrical appliance status recognition and abnormality detection unit as described above is a unit which compares a power waveform appearing when a household electrical appliance is not operating normally with a power waveform stored in advance. A pattern of the power waveform is stored in a server or the like when the household electrical appliance is operating normally after connection of the household electrical appliance to a smart tap.

Through detection in the above-described manner, a malfunction in, trouble with, and an electric leak in a household electrical appliance, an abnormality in wiring (e.g., an electric leak), and an abnormality in a smart tap itself can be detected.

With the above-described constituent members, a smart tap can also be structured in the manner below.

A wireless device which measures power and transmits current and voltage waveforms is provided on the reverse of a non-metal resin member at a front on the plug socket side of a smart tap. In this case, since a portion around a reception section of the communication device is made of a non-metal material, the communication performance is not lowered. A heating section of a power control device section is installed behind the communication device. The temperature inside the smart tap and the temperature of a metal housing can be kept at or below 80°C by dissipating heat to the housing or a metallic heat sink via a heat dissipation member (a sheet or an adhesive sheet) with, e.g., insulation property. That is, heat generation can be suppressed without impairing the communication performance of the tap, and an inexpensive device can be used instead of a power control device with low on resistance, without reducing the life of each device in the tap.

If a smart tap is structured such that a wireless device is provided on the reverse of a non-metal resin which does not lower the communication performance and such that a power control device is installed behind the wireless device, it is also possible to use a housing of a highly thermal conductive resin composite material which is highly thermal and conductive and has insulation property and interpose an insulating heat dissipation member between a heating section and the insulating highly thermal conductive resin housing.

This allows reduction in heat generation without impairing communication performance and allows use of an inexpensive control device.

A communication device can be installed inside a smart tap, particularly at a portion of, e.g., metal which suffers little communication interruption. For example, in a structure with a communication device provided at a side, a resin housing suffering little communication interruption is used. The amount of heat generation can be kept at or below 80°C by selecting a device which generates a small amount of heat, i.e., has a small on resistance value as a power control device.

A sensing and communication unit includes at least one of publicly known sensors, such as a human sensor, a temperature sensor, a humidity sensor, an air volume sensor, an illuminance sensor, and a locking sensor installed in a building, which sense the status in the building and a unit which wirelessly transmits a result of sensing by the sensor directly to a server or to a nearby smart tap.

When the sensing and communication unit as described above is used, data from the sensor which is transmitted to a server by the sensing and communication unit is added to information transmitted from a smart tap to the server, processing is performed in the server on the basis of the pieces of information, and a result of the processing is transmitted to a smart tap of the present invention.

A household electrical appliance remote control function can be added to a smart tap of the present invention. A remote control function when each household electrical appliance itself has a power control function is a remote control for an air conditioner, a television, a fan, an electric carpet, an in-door ceiling light, and the like and is a function of turning on/off or performing other operation adjustment on the household electrical appliances through remote control. As the household electrical appliance remote control function, infrared rays and a home automation terminal, ECHONET Lite, a communication interface for ECOHNET, or the like can be adopted.

It is possible to add such a remote control function to a smart tap and cause the remote control function to function as one of control units which control a power plug connected to the smart tap. In this case, a remote control operation function of a connected household electrical appliance itself can be used in addition to operation control on the household electrical appliance through a power plug. Additionally, since operation of the remote control is not performed directly by a human but is performed as part of control by a smart tap of the present invention, finer operation aimed at reduction in the amount of power and reduction in peak power can be performed on the basis of a control signal from a server.

Household electrical appliances which do not have a function of controlling power in themselves, such as a light (e.g., a light bulb), an electric pot, a refrigerator, an IH heater, a toilet seat with a warm-water shower feature, and a coffee maker, do not need a remote control function. A power control device of a smart tap of the present invention can control the household electrical appliances.

If a smart tap is always kept on, the power consumption of the smart tap is higher than the standby consumption of household electrical appliances. Thus, a function of turning on/off a smart tap when a timer, a sensor of every kind, such as a human sensor, or a particular electric appliance (e.g., an in-door light of a store or the like) is turned on/off and a function of sleeping and waking up when a connected household electrical appliance is powered off/on can also be provided. In particular, as a function of a smart tap, the smart tap is designed such that a power threshold value is set for determining how to wake a home appliance from a sleep state. For example, the threshold value is set to 1 to 10 W, and the smart tap can wake a home appliance from a standby state by power above the threshold value.

In order to check the operating status of the on/off function and the sleep or wakeup function, an LED device or the like can be installed on, for example, an outer surface at a front of a smart tap or an inner surface where transmitted light can be displayed (the operating status can be checked through a lighting-up display on the LED or the like).

Construction of an EoD system based on energy computerization using a smart tap according to the present invention, i.e., an example using a power plug according to the present invention will be described below.

According to a smart tap of the present invention, it is conceivable to pass through phase 1 (visualization of energy consumption and learning and monitoring human activity), phase 2 (high-level power management based on an EoD type power network), phase 3 (power coloring based on an in-home nano grid), and phase 4 (energy interchange based on a regional nano grid) in this order.

In phase 1, a pattern of in-home energy consumption is visualized to achieve enhancement of a consumer's consciousness of power saving, and the statuses of individual household electrical appliances and the pattern of activity of an ordinary person to use the household electrical appliances are learned and monitored to find a waste of power and support the ordinary person's activity.

More specifically, a power plug connection apparatus according to the present invention can be used in the utilization situations in phases 1 to 4 below.

(Phase 1)

Publicly known units which measure a voltage waveform of an alternating current can be adopted as a voltage waveform measurement unit and a current waveform measurement unit according to the present invention. Measurement in the units is performed at a high sampling rate of 10 to 30 kHz and 16-bits per sample.

Voltage and current waveforms obtained by the voltage waveform measurement unit and the current waveform measurement unit are processed in an arithmetic unit, and a processing result is transmitted to a server by a communication unit. A microcontroller or the like with a built-in DSP is preferably adopted as the arithmetic unit.

Most household electrical appliances of late years internally include an advanced control device, such as a switching power source or an inverter. A waveform characteristic of each household electrical appliance appears in a current waveform within one AC cycle. For this reason, even if there are household electrical appliances which consume the same power, a household electrical appliance in question can be identified by comparing patterns of current waveforms, and the operation status of the household electrical appliance can be checked.

The function is a function totally different from that of a conventional smart tap which simply visualizes power. For the function, the arithmetic unit uses a feature quantity of voltage and current waveforms as a feature quantity for identifying each connected household electrical appliance. Examples of the feature quantity include peak values, periods, and vectors at a base point in time of the current and voltage waveforms. Even by such feature quantities, a household electrical appliance could be identified with high accuracy.

As described above, a feature quantity can be derived by the arithmetic unit and be transmitted to the server by the communication unit. If feature quantities are not derived, a communication speed of 16 bits x 20,000 Hz x 2 = 640,000 Hz is required in view of the amount of data, and transmission is impossible at a communication speed (up to 250 kbps) supported by ZigBee. For higher communication speed, a communication unit using a wide band cannot be adopted in terms of size reduction and power consumption reduction.

In ZigBee, a header including a destination and a source and a data length and a checksum are added to a variable payload of up to 78 bytes in one packet, and the packet is transmitted. In this case, a packet with a setting command and a property set in the payload section is transmitted and received. For example, a command received by a smart tap of the present invention is 16 bits long, and a setting value is 0 to 592 bits long. The format of data to be transmitted is such that the data is composed of 16 bits, an acquisition time of 32 bits, and a data section of 16 to 576 bits.

As described above, due to limitations on communication speed, raw data of voltage and current waveforms which are large in data amount cannot be transmitted as they are. By setting a table for feature extraction, the arithmetic unit in the smart tap can calculate feature quantities of voltage and current waveforms. There are not many feature quantities required to identify an individual household electrical appliance and check the operation status of the household electrical appliance.

Phase 1 is divided into (1) a feature learning step, (2) a household electrical appliance learning step, and (3) a household electrical appliance recognition step for a household electrical appliance. Communication in each step will be described.

(1) Feature Learning Step

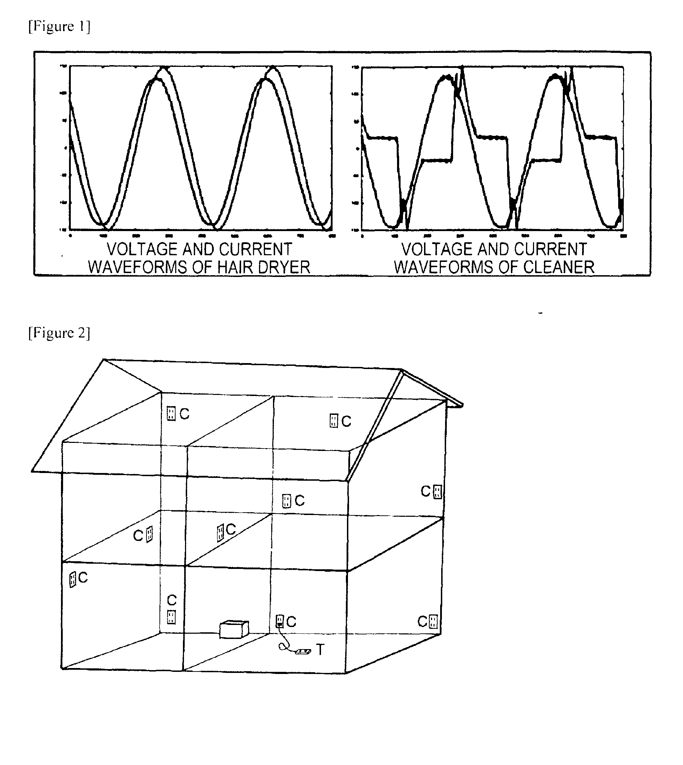

Eigenvectors which are obtained by principal component analysis of current waveforms collected in advance from a large number of household electrical appliances are used. Feature quantities are obtained by calculating the inner products of current waveform measurement results derived from current waveform measurement and the eigenvectors. As shown in Figure 1, the voltage waveforms and the current waveforms of household electrical appliances are different.

Analysis of features of these waveforms is necessary for identifying a household electrical appliance.

Since conditions for obtaining feature quantities do not depend on individual household electrical appliances, data for comparison for obtaining feature quantities are learned in advance and are saved in an arithmetic unit or the like of a smart tap of the present invention.

The format of a message for transmitting voltage and current waveforms from the smart tap to a server in advance is, for example, such that waveform information is composed of WH of 16 bits, an acquisition time of 32 bits, and a period of 16 bits and such that waveform data is composed of WD of 16 bits, an index of 16 bits, the number of data of 16 bits, a voltage (i) of 16 bits, a current (i) of 16 bits, a voltage (i+k) of 16 bits, and a current (i+k) of 16 bits. The format of a message for setting a feature extraction table in the smart tap is such that table information is composed of FH of 15 bits, a feature number of 8 bits, and a period of 16 bits and such that table data is composed of FD of 16 bits, an index of 16 bits, the number of data of 16 bits, a table (i) of 16 bits, and a table (i+k) of 16 bits.

In view of the amount of data, these data do not fit into one packet. Thus, data for one cycle are held in an internal memory of the smart tap, and the data are transmitted in a plurality of packets. Waveform information is transmitted in a packet with the identifier WH, and a data section is transmitted to a server in a plurality of packets together with the identifier WD, a start index, and the number of data.

Similarly, at the time of setting a feature extraction table, table information indicated by the identifier FH and a data section indicated by the identifier FD are transmitted to the server in a plurality of packets.

(2) Household Electrical Appliance Learning Step

In the step of learning an individual household electrical appliance, since learning is performed with use of feature quantities extracted by the smart tap, only a small number of feature quantities may be transmitted.

As an example of the format of a feature quantity extraction message, the message is composed of DF of 16 bits, an acquisition time of 32 bits, an effective voltage of 32 bits, an effective current of 32 bits, active power of 32 bits, integral power consumption of 32 bits, a feature quantity of 32 bits x 4, and a period of 16 bits. DF is used as an identifier indicating the type of data, and a total of 320 bits (the acquisition time, the effective voltage, the active power, the integral power consumption, the four feature quantities, and the period) as one message is transmitted to the server in one ZigBee packet. Alternatively, a current waveform and a voltage waveform may be transmitted as feature quantities to the server.

(3) Household Electrical Appliance Recognition Step

In the household electrical appliance recognition step, the server performs recognition with use of a small number of feature quantities extracted in the smart tap, as in the household electrical appliance learning step. At this time, learning is performed with the same type of feature extraction message as in the household electrical appliance learning step.

(Phase 2)

After recognition of household electrical appliances by features of the household electrical appliances in phase 1, phase 2 starts.

Phase 2 aims to more positively reduce energy consumption by a power management technique called EoD in which a server for power supply controls supply of power to household electrical appliances according to the power supply status and the priorities for use of household electrical appliances in use while performing arbitration.

EoD is fundamentally different in mechanism from a traditional power network in which a household electrical appliance is always supplied with as much power as needed when a load appliance as the household electrical appliance is powered on and is a mechanism for determining the priorities of appliances and assigning, in a best-effort manner, the amount of power and a time period available to each appliance through arbitration.

Phase 2 has a defined demand arbitration protocol for a single power source selected from among a plurality of power sources including system power, photovoltaic power generation (PV), wind power generation, small hydropower generation, a fuel cell, and a storage battery in a house, a building, and a facility.

The procedures of the demand arbitration protocol of EoD will be described below.

A. A power request message from the side of a household electrical appliance or the like is transmitted from a smart tap to a server at fixed time intervals through two-way packet communication. The power request message contains the amount of power required to operate the household electrical appliance connected to the smart tap and/or the amount of power successively required during operation.

B. The server determines the priorities of the household electrical appliance having sent the power request message and running household electrical appliances (load appliances) on the basis of a presently suppliable amount and/or a pattern of life in a home acquired in phase 1, the amounts of power consumption of household electrical appliances and the like, the difference between the amount of planned power and the amount of power consumption, and the like.

C. According to the priorities of the load appliances, a power assignment message including the amount of power permitted to be used and a permitted time period to each appliance and a refusal message to an appliance which cannot be supplied with power are transmitted through two-way packet communication. A household electrical appliance which is permitted to use power starts or continues operation or operates with the reduced or increased amount of power consumption.

D. A household electrical appliance permitted to use power runs with permitted power for a permitted time period. A household electrical appliance refused permission to use power makes a reassignment request (EoD) after a fixed time period.

In the series of steps, when power to a household electrical appliance is turned on by a user's manipulation or a program in a sensor, a timer, or the like, power for operating the household electrical appliance is not first supplied to the household electrical appliance. First, a packet containing the amount of requested power of each household electrical appliance is transmitted from a smart tap to a server. The server having received the packet determines the supplying capability of a single power source or a plurality of power sources and sends, in response, a control signal indicating permission for supply to the smart tap if the requested power can be supplied.

The smart tap having received the control signal starts or stops supply of power to the connected household electrical appliance in accordance with the control signal.

Processing in the server in the series of processes and determination about supply to a household electrical appliance will be described in more detail. The server determines supply of power to a household electrical appliance in consideration of the amount of power suppliable from the single power source or the plurality of power sources.

In particular, assume a case where there is little surplus of suppliable power over the sum of power used by household electrical appliance which may be used. If peak cutting, such as setting an upper limit for power, is to be performed, information on, e.g., the ranking of the priorities of household electrical appliances in operation is successively updated, as needed. When a new electric appliance is powered on, the ranking of the priorities of the household electrical appliances including the new electric appliance is updated. The server determines whether to supply power to the newly powered-on household electrical appliance, on the basis of the amount of suppliable power and the ranking of the priorities of the household electrical appliances.

Further consideration can be given to the priority ranking by additionally using an ordinary person's pattern of activity as information for determining whether to supply power to a household electrical appliance. A power use model is created in the server by learning the ordinary person's pattern of activity, and a power use plan is created in advance. It is also possible to perform control such that an integrated value of the instantaneous peak power of household electrical appliances does not exceed supplied power or power in the power use plan, by constantly obtaining peak power in real time and comparing the peak power with the power use plan.

This method allows a user himself/herself to reduce power to be used by a desired amount by setting the amount of maximum suppliable power.

As described above, implementation of an EoD system allows determination of the priorities of individual household electrical appliances in view of characteristics of power sources for the household electrical appliances and power and stopping of or reduction in power supply to a household electrical appliance with low priority.

Appliances incorporated in an EoD system include three types of appliances: a household electrical appliance which is an appliance on the demander side, a power supply system which is an appliance on the supplier side, and a storage battery which temporarily stores power.

In phase 2, arbitration on the demander side for a single power source is performed. Examples of a household electrical appliance will be given and classified into three groups from the standpoint of the type of control.

A. Adjustable - In a light, a dryer, or the like, making the amount of supplied power smaller by a certain amount than requested power degrades performance but does not affect practical use much. Power requested from the appliance side is not supplied to such an appliance, and supplied power to the appliance can be reduced.

B. Waitable - A household electrical appliance, such as a washing machine or a rice cooker, which runs automatically for a certain time period after startup only needs to complete operation by a target end time. The timing for startup may be delayed. For such a household electrical appliance, the timing of actual startup can be shifted from a time when startup is requested.

C. Suspendable - A household electrical appliance, such as an air conditioner or a refrigerator, which controls heat can maintain the temperature even after operation is suspended for a short time period and can be suspended during running.

Each household electrical appliance falls or does not fall into each of categories A to C. In light of the fact that each household electrical appliance can be put or cannot be put in each of the three categories, household electrical appliances can be classified into a total of eight groups. A household electrical appliance which is put in none of the three categories is absolutely required to run in any case and can be said to be a household electrical appliance with highest priority for power supply.

A result of classification in the above-described manner is shown in Table 1.

[Table 1]

| Class | Adjustable | Waitable | Suspendable | Home appliance |
|---|---|---|---|---|
| 1 | YES | YES | YES | notebook PC and boiler |
| 2 | YES | YES | NO | toilet seat with warm-water shower feature and microwave oven |
| 3 | YES | NO | YES | heater, air conditioner, and refrigerator |
| 4 | YES | NO | NO | TV and dryer |
| 5 | NO | YES | YES | dishwasher and washing machine |
| 6 | NO | YES | NO | rice cooker and toaster |
| 7 | NO | NO | YES | copier and electric pot |
| 8 | NO | NO | NO | gas security detector, respirator, and network appliance (e.g., router) |

Table 2 shows properties of a household electrical appliance class. In the EoD demand arbitration protocol, a household electrical appliance requesting power first transmits a power assignment message with properties added to a server.

The server compares the requested power with suppliable power. If supply of the requested power is possible, the server transmits a power assignment message to the smart tap. On the other hand, if supply of the requested power is not possible, the server reduces the amount of power supply to a household electrical appliance which is presently in use and has low priority or transmits a message to refuse supply of power to the requesting household electrical appliance.

[Table 2]

| Property | Value | Remarks |
|---|---|---|
| Home appliance ID | ID | identifier of home appliance |
| Home appliance class | 1 to 8 | |
| Requested power | numerical value (W) | common to all home appliance classes |
| Minimum startup power | numerical value (W) | home appliance classes 1 to 4 |
| Suspendable period | numerical value (sec) | home appliance classes 3, 4, 7, and 8 |
| Estimated time of startup | time | home appliance classes 2, 4, 6, and 7 |
| Estimated running time period | numerical value (sec) | |
| Priority | 0 to 1 | 1 : highest priority |
| Supply method | DC, AC, or voltage | |

As described above, the server notifies the smart tap of whether power assignment is possible. If the notification is a reply to the power request, the notification contains whether to permit or refuse assignment. The server sets whether to suspend supply or change assigned power in a message to a running household electrical appliance.

If assignment is permitted or in the case of reassignment, the maximum value of power assigned to a household electrical appliance in question (assigned power) and a time period for assignment are added as properties. If assignment is refused or a running household electrical appliance is to be stopped, a time when the household electrical appliance makes a power request again is added. Supply power is the ID of a power source which supplies power and is required by a distributed power source in phase 3.

(Phase 3)

Unlike power supply control performed in phase 2, in phase 3, power is supplied not only from a system power source (including a plurality of systems) which is the most common power source but also from a plurality of power sources including photovoltaic power generation (PV), wind power generation, small hydropower generation, a fuel cell, and a storage battery. In addition, control of a connected household electrical appliance by a server through smart tap control is performed in the same manner as in the control in phase 2.

Efficient management of distributed power sources is performed by an in-home nano grid having a power coloring function of limiting a power supply source for each power source (a function of distinguishing among power sources of supplied power).

If a plurality of distributed power sources are introduced into a home, the EoD protocol in phase 2 is changed to allow selection of power from among the plurality of power sources, and the power sources and household electrical appliances are associated while a balance between demand and supply is kept, thereby implementing efficient power supply. To this end, appropriate measures need to be taken on the basis of characteristics of demand and characteristics of the power sources. In this case, priority for power supply needs to be determined for each power source. Power sources are classified into four types, as shown in Table 3, according to the presence or absence of stability indicating whether suppliable power is invariant or controllable or not and the presence or absence of readiness indicating whether delay occurs when supplied power is changed.

For example, system power from a power company has high stability and high readiness. The suppliable power of a photovoltaic cell depends on weather. The photovoltaic cell has readiness but lacks in stability.

[Table 3]

| Class | Stability | Readiness | Example of power source | Home appliance to which power can be supplied |
|---|---|---|---|---|
| A | ○ | ○ | system power | 1 to 8 |
| B | ○ | × | fuel cell | 1, 3, 5, and 7 |
| C | × | ○ | photovoltaic cell | 1, 2, 5, and 6 |
| D | × | × | | 1 |

Each power source has various types of parameters, as shown in Table 4 below. A fuel cell or cogeneration simultaneously performs power generation and hot-water supply, and the amount of suppliable power varies depending on the amount of hot water. A user can set upper limit values for the amount of used power and the amount of power by setting maximum supplied power and setting a ceiling on integral power consumption.

A storage battery is placed as a household electrical appliance when the storage battery is charged and is placed as a power source when the storage battery discharges.

[Table 4]

| Property | Value | Remarks |
|---|---|---|
| Power source ID | ID | identifier of power source |
| Power source class | A to D | |
| Supplied power | numerical value (W) | power presently being supplied |
| Maximum power | numerical value (W) | presently suppliable power |
| The amount of suppliable power | numerical value (Wh) | presently suppliable integral power consumption |
| Ceiling | numerical value (Wh) | user-set upper limit value |
| Delay time period | numerical value (yen /W) | delay time period at the time of power change |
| Power cost | numerical value (yen /Wh) | electricity expense per unit power amount |
| $CO_2$ emissions | numerical value (ml/Wh) | emissions per unit power amount |
| Power transmission method | DC, AC, voltage, or the like | |

In EoD, a power source selection protocol can determine a supply source and a supply destination by the procedures below.

A. Each power source transmits power source properties to a server.

B. A power plug apparatus transmits a message with household electrical appliance properties added for power assignment to a household electrical appliance to the server.

C. The server selects ones capable of supplying power from the power sources in Table 3 according to the class of the household electrical appliance and determines the priorities of the power sources for the household electrical appliance such that priority becomes higher with decrease in power cost or $CO_2$ emissions.

D. The server determines, in order from the highest-priority power source to the lowest-priority power source, whether power supply is possible in the same manner as in the demand arbitration protocol and transmits a power assignment message to the power plug apparatus.

E. Upon receipt of the power assignment message, the power plug apparatus supplies power to the associated household electrical appliance in accordance with the message.

A storage battery switches between a charging mode and a supply mode according to the amount of accumulated electricity, the statuses of other power sources, and a supply status. The storage battery makes a power request as a load appliance in the charging mode and takes part in power arbitration as a power source in the supply mode.

(Phase 4)

In phase 4, an in-home nano grid is expanded to a nano grid on a per neighboring region basis.

At this time, a power plug apparatus needs to be configured so as to support exchange of information in a region.

A smart tap according to the present invention is used in the above-described EoD system and will be more concretely described below.

Figure 2 of the present invention shows a view of installation of mounted type electric outlets for an on-demand power control system. Reference character C in Figure 2 denotes a mounted type electric outlet, and a plurality of smart taps of the present invention are installed as mounted type electric outlets in a building. A tap denoted by reference character T in Figure 2 can also be arbitrarily used. In principle, one server is installed for one residence. A communication network which allows communication with all mounted type electric outlets in the residence is also built.

If T is connected to C described above, smart taps of the present invention are connected in series in one system. In this case, the process of stopping the function of either one (preferably the electric outlet C) is performed.

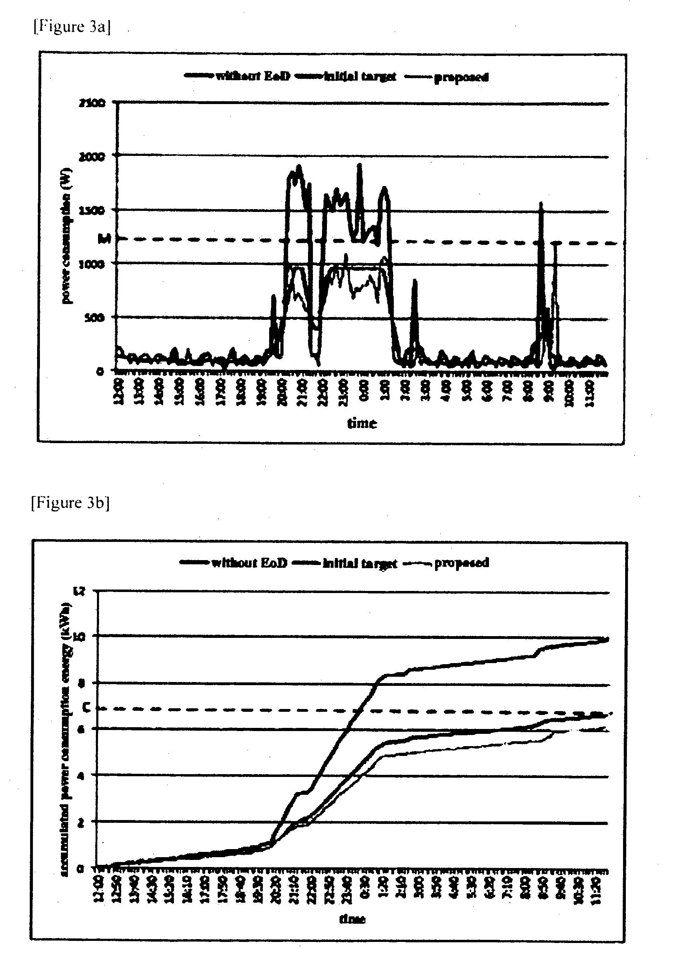

Figures 3 are each a conceptual chart showing the transition of power across one house when various types of household electrical appliances whose input voltages are 100 V are used in the one house.

In Figures 3, a solid line indicates power without EoD, a dashed line indicates a target value for EoD, and an alternate long and short dash line indicates a control simulation result of a case where EoD control is performed on the basis of actual measurement values of the household electrical appliances.

Figure 3a shows data on instantaneous peak current values from noon on a certain day to noon on the next day. The values are real-life power values with respect to a power plan as a reduction target indicated by a line having flat peaks.

A line irregularly fluctuating in an area below a dotted line is a line showing the control simulation result. A line which crosses the dotted line is data showing real-life data.

According to control in Figure 3a, actually used power falls within a range below 1200 W indicated by a dotted line M, which shows that an instantaneous peak does not exceed 1200 W.

Figure 3b is a chart obtained by accumulating the instantaneous power consumption shown in Figure 3a and shows data when a value for limiting an instantaneous power value for one day is set to be not more than 30%. Real-life data exceeds a target accumulated power consumption value indicated by a dotted line.

However, if control is performed with use of a smart tap of the present invention while the value for limiting is set to be not more than 30%, a result which rises slightly below a line on a dotted line C can be obtained as a simulation result at noon on the next day under the control.

These results show that the present invention can guarantee that power consumption does not exceed a cut upper limit when an upper limit peak cut rate for the power consumption is set to, for example, 30%, i.e., can quantitatively guarantee power reduction.

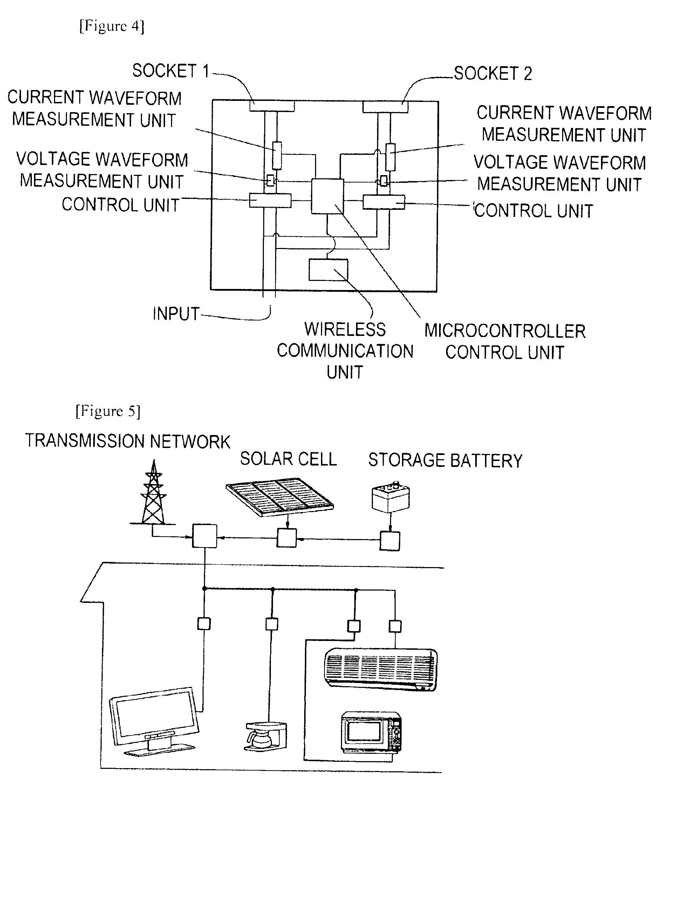

A description will be given with reference to Figure 4 showing a view of the internal configuration of an example of a mounted type electric outlet as a smart tap according to the present invention.

A smart tap of the present invention is supplied with power by wiring in a building, like a general mounted type electric outlet or a general tap. The smart tap bifurcates, in its inside, into two if the smart tap is a two-socket electric outlet and into three if the smart tap is a three-socket electric outlet and also functions as an electric outlet for output having, e.g., two or three sockets. The smart tap is configured to include components required for that purpose.

In addition to the configuration, the present invention includes, for each output, a voltage waveform measurement unit, a current waveform measurement unit, measurement of the amount of power and computation of the amount of power, an arithmetic unit device, and a control unit and further includes a communication unit for transmitting signals from these units to a server (not shown) and receiving a control signal from the server.

Note that, even in a mounted type electric outlet or a tap having two or more sockets, one such arithmetic unit and one such communication unit may function collectively for a plurality of outputs.

A smart tap of the present invention can be installed not only in a solitary house, a collective housing, an apartment house, and a store with a house but also in an office, a building, a factory, a multi-tenant facility, a mass merchandiser, a hospital, an elderly facility, a supermarket, and the like. Sites in each of these buildings where smart taps of the present invention are installed are places on wall surfaces of the building where smart taps are generally installed and arbitrary places where smart taps are installed as taps, as shown in Figure 2. In principle, a server as a communication destination for the communication unit is preferably installed in the same building. Generally, one server is installed in one building. If a plurality of residences are contained in one building, as in a store with a house, an apartment house, or the like, or if one building (e.g., an office, a factory, or a multi-tenant facility) is divided into a plurality of units, a server can be installed for each of residences, units, or the like. One server can communicate with a plurality of smart taps, and a server capable of communication and processing of obtained information for mounted type electric outlets and taps installed in, e.g., a general residence can be selected.

Note that if smart taps are installed not in a solitary house, a collective housing, an apartment house, or a store with a house but in an office, a building, a factory, a multi-tenant facility, a mass merchandiser, a hospital, an elderly facility, a supermarket, or the like, it is also possible to provide a server in a place other than a roofed and walled structure and utilize a cloud.

It is further possible to utilize a cloud, an external server, or the like via a gateway (GW) such as a home gateway (HGW). For example, in-home EoD system control can be performed by a GW, and a cloud, an external server, or the like can be used for an enormous volume of total power data involved in life.

Additionally, if EoD control is performed on a plurality of homes, a building, or the like by using taps of the present invention in the case of, e.g., a smart community, on which home or office data in question is can be identified by using a GW.

As shown in Figure 5, photovoltaic power generation and wind power generation that are renewable energy sources, a storage device, a storage battery device, such as a hybrid vehicle or an electric vehicle, and other power sources can be connected as power sources to supply electricity to one home, in addition to an existing transmission network. This allows supply of electricity to a home from two or more types of power sources.

In this case, selection of a given one of plurality of power sources, determination of the amounts of power supply from the respective power sources, and selection of a household electrical appliance to which power is supplied from the given power source are performed based on the matters in, e.g., Tables 3 and 4 described above by connecting respective smart taps of the present invention to the power sources. This allows reduction in energy loss, large-scale power saving with enhanced comfort, and control, such as efficient peak cutting.

By using a plurality of power sources as described above, a smart tap of the present invention can be used even in, for example, a case where a DC power source is connected to a household electrical appliance instead of an AC power source in, e.g., an eco-house. In this case, an AC/DC conversion device in a residence or the like converts, of AC power supplied to the residence, power supplied to all household electrical appliances or power supplied to some household electrical appliances to DC power, and a smart tap of the present invention is used as a tap for supply of DC to household electrical appliances.

Note that, in the case of direct current (DC) feeding utilizing photovoltaic power generation or wind power generation using renewable energy or a power source unit, such as a fuel cell or a storage battery, a DC/DC converter device converts power to power supplied to all household electrical appliances or power supplied to some household electrical appliances, and a smart tap of the present invention can also be used as a tap for supply of DC to household electrical appliances. A DC supplied voltage in this case can be set to a voltage as low as, e.g., 24 V or 12 V with safety in mind. Examples of a household electrical appliance as a DC supply destination include a low-power appliance (e.g., a light), a PC and its associated appliances, and household electrical appliances which have used an AC/DC converter on an individual basis, such as a telephone set. In particular, in a household electrical appliance which has used an AC/DC converter, AC/DC conversion loss is reduced to achieve higher-efficiency power use.

For household electrical appliances which consume much power, such as an 1H cooker and an air conditioner, an AC power source can still be adopted in view of the risk of handling a high-voltage (200 V) direct current. In this case, part of power branching from AC power is converted to DC. If a high-voltage direct current can be safely handled, it is also possible to convert all alternating currents supplied from the outside to direct currents and use a smart tap of the present invention for such direct currents.

Among smart taps of the present invention, a smart tap for a DC power source adopts a voltage sensing unit and a current sensing unit for DC and control for DC. With this configuration, the smart tap can be used while being mounted in a wall or can be used while being inserted in an electric outlet provided on a wall like a table tap, in the same manner as in a smart tap for AC. Even in this case, the smart tap senses current and voltage waveforms specific to a household electrical appliance and recognizes the household electrical appliance connected to the smart tap.

Particularly when electricity is supplied from two or more types of power sources to one home by connecting DC power sources, such as photovoltaic power generation and wind power generation that are renewable energy sources, a storage device, and storage battery devices (e.g., a hybrid vehicle and an electric vehicle) as power sources for supply to the home in addition to an existing transmission network, and a smart tap for DC is used, as described above, direct currents supplied from photovoltaic power generation, a storage device, or a storage battery device need not be converted to alternating currents, which prevents conversion loss. As for these DC power sources, DC current systems can be collectively controlled by installing a smart tap at a panel board for DC power sources or installing a smart tap instead of a panel board. It is also possible to individually control supply of power from power sources by installing a smart tap downstream of the power source side.

In this case, selection of a given one of a plurality of power sources, determination of the amounts of power supply from the respective power sources, and selection of a household electrical appliance to which power is supplied from the given power source are performed by connecting respective smart taps of the present invention to the power sources. This allows reduction in energy loss and control, such as efficient peak cutting.

In conclusion, smart taps of the present invention, which are each installed as a mounted type electric outlet mounted in a wall section, a ceiling section, a floor section, or the like, installed as a tap connected to such a mounted type electric outlet, a conventional mounted type electric outlet, or a conventional tap, or installed at a panel board, can control power supplied to household electrical appliances and power lines connected downstream of the smart taps, regardless of whether AC or DC.

As a first form of a smart tap, for example, a smart tap having the internal structure as shown in Figure 6 can be used. Note that MOSFETs are adopted as control devices in the drawings below.

Figure 6 is a view schematically showing the internal layout of a smart tap as a two-socket electric outlet. Four MOSFETs 1 and one current measurement unit 2 are provided as control units for each socket. Although not shown, one voltage measurement unit is provided for each socket. The smart tap is provided such that two sockets share one arithmetic unit and one communication unit. As can be seen from Figure 6, a circuit board for an arithmetic unit power source is provided, the MOSFETs 1 are provided at four corners to facilitate dissipation of heat generated in the MOSFETs 1 to outside a power plug, and an arithmetic unit 3 and a communication unit 4 are installed as far apart from the MOSFETs 1 as possible. Note that the number of MOSFETs 1 is at least two and that four to eight MOSFETs 1 can be provided.

It is necessary to prevent the arithmetic unit 3 and the communication unit 4 from being heated as far as possible by adopting this layout.

Since adoption of a control unit that is a power control device, such as a MOSFET, which generates a small amount of heat, i.e., has a small on resistance value reduces the amount of heat generation, use of a metal material impenetrable to radio waves is unnecessary. At least part of a housing can be made of resin with a small heat dissipation effect, and radio wave penetrability necessary for communication with a server can be guaranteed.

The amount of heat generation of a power control device can be kept at or below 80°C by selecting as the power control device such a device which generates a small amount of heat, i.e., has a small on resistance value.

As a second form, an example is shown in Figures 7 and 8 where the MOSFETs 1 as control units (two per socket) are provided at a board immediately behind a front which is made of, e.g., resin and through which radio waves can pass or a board behind the board, unlike the smart tap structure shown in Figure 6. Figures 7 and 8 are views of the configuration of an example of a smart tap of the present invention. Figure 8 is a view of a state in which some of the components in Figure 7 are assembled, as seen from another direction.

Referring to Figures 7 and 8, the communication unit 4 and a board for the communication unit 4 are installed on the reverse of, for example, a central portion of the front 6 of the smart tap that is made of a material, such as resin, which is a non-metal resin material and permits passage of radio waves. For this reason, a signal from the communication unit 4 can be communicated to, for example, a server through the front 6 of the smart tap. Although not shown, an LED indicating the operation status of the smart tap and a board for the LED, and a board for rewriting firmware for a wireless module and firmware for a microcontroller can be provided at a central portion of the board. If the smart tap is of the mounted type, both of rewriting and updating with use of a USB terminal and wireless rewriting can be used to rewrite the firmware for the wireless module and the microcontroller.

The MOSFETs 1 are provided near central portions of longer edges of a board 7 which is located behind the front 6 of the smart tap. Although not shown, an insulating heat dissipation sheet is provided so as to be in contact both with the MOSFETs 1 and with a housing 8 in case that operation of the smart tap causes the MOSFETs 1 to generate heat.

For this reason, heat generated in each MOSFET 1 is transferred to the insulating heat dissipation sheet as a heat dissipation member and is then transferred to the metal housing 8 or a metallic heat sink. The housing 8 smoothly dissipates heat from the MOSFET 1 by dissipating heat into a wall in which the smart tap is installed and can keep the temperature inside the smart tap and that of the housing at or below 80°C.

Thus, an inexpensive device can be used instead of a power control device with low on resistance.

A board 9 which is provided with a voltage waveform measurement unit, a current waveform measurement unit, and an arithmetic unit, such as a CPU, all of which are not shown, is installed behind the board 7 provided with the MOSFETs 1. Heat generated in the MOSFETs 1 is not transferred directly to the units and is conducted to the housing 8 in contact. The units are not excessively heated.

A board 10 is also installed behind the board 9. A control device 11, such as a MOSFET, supporting a high load can be provided on the back of the board 10 in case that a household electrical appliance to be connected is under high load.

If higher priority is given to reduction in the thickness of the smart tap itself, a semiconductor device, such as a MOSFET, having a power control and switching function can be provided at the board 7. If there is a high degree of flexibility in setting the depth of the installed smart tap, a MOSFET can be installed at the board 10. Thus, a power control device serving as a heating section can be used in any of the configurations.

As described above, it is preferable to provide a MOSFET at a part as far apart from a microcontroller and a wireless module as possible for a high-current household electrical appliance or electric appliance. A smart tap of the present invention can be constructed by arranging boards in the above-described manner. The layout of boards and which elements are to be provided at each board can be appropriately changed without undermining the efficacy of the present invention.

Use of Smart Tap for Each Connected Household Electrical Appliance

A smart tap of the present invention identifies a connected household electrical appliance in the above-described manner and, when the household electrical appliance is powered on, performs control on operation of the connected household electrical appliance through communication with a server together with control on other household electrical appliances. To more appropriately use the smart tap for various types of household electrical appliances, the smart tap can be provided with an infrared ray transmission function or a remote control function for, e.g., a home automation terminal.

When a household electrical appliance is to be operated with use of such a smart tap, the smart tap is used in one of three modes depending on the type of the household electrical appliance.

A first mode corresponds to the case of household electrical appliances having a so-called remote control function, such as a TV, lights in a bedroom and a living room, and some air conditioners, a case where a household electrical appliance itself has a function of controlling power consumption. In this case, units which a smart tap fulfills when the smart tap is connected include a voltage waveform measurement unit, a current waveform measurement unit, a current measurement unit, a voltage measurement unit, a power consumption computation unit, a communication unit, a sensing unit, and a remote control unit, and the smart tap is provided with these units. That is, a home appliance itself has a remote control function and a control function, interlocking of the functions by a remote control bridge function of a smart tap allows control of power, and a switching function of the smart tap allows turn-on/off of power. A smart tap detects how much power consumption each home appliance requires and notifies a server of a request message. After reception of a power supply message as a result of determination of the power statuses of other home appliances by the server, the smart tap performs supply of power to a home appliance, stopping of supply, suspension of supply, and power adjustment.

A second mode corresponds to the case of household electrical appliances, such as a microwave oven, a washing machine, a humidifier, a hot-air blower, and some rice cookers, which have no remote control function and is complicated in power control. If such home appliances are connected to a smart tap, the smart tap measures and computes how much power consumption each home appliance requires, notifies a server of a request message, and receives a supply message as a result of determination of the power statuses of other home appliances by the server. The smart tap performs supply of power or stopping of supply to a household electrical appliance. Note that, in this case, the smart tap cannot perform control of power to a home appliance and only has a turn-on/off function.

Since such a home appliance may become a network home appliance having a remote control function in the future, a tap will be able to perform the same control as that for a remote control home appliance at that time.

A third mode corresponds to the case of present household electrical appliances which are household electrical appliances, such as lights in a hallway, a kitchen, a washroom, a toilet, a bathroom, and the like, an 1H appliance, a refrigerator, an electric pot, and a toilet seat with a warm-water shower feature. If such household electrical appliances are connected to a smart tap, all units including an arithmetic unit of the smart tap are used to control the household electrical appliances.

A chip fuse, a poly switch, a glass tube fuse, or the like for overcurrent protection can be connected to an internal circuit of a smart tap of the present invention in order to, e.g., prevent a reverse current from a connected household electrical appliances and prevent an abnormal current from each power source.

In addition, the internal circuit can be provided with a switching surge protection function for suppressing a high voltage generated when a varistor or a power control semiconductor device is turned on/off and a heating protection function for suppressing heat generation in a power control device for overvoltage protection.

When a connected household electrical appliance is powered off and is in a state requiring only standby energy, it may be necessary to reduce the power consumption of a smart tap connected to the household electrical appliance or the power consumption of a circuit itself inside the smart tap for supplying power to a socket of the smart tap.

In this case, the need may arise to reduce the power consumption of the smart tap itself or the circuit itself inside the smart tap to which the household electrical appliance is connected as much as possible. For this reason, if power supplied to a connected household electrical appliance is not more than the standby energy of the household electrical appliance, a smart tap enters a sleep state and remains in the state. In the sleep state, all functions of the smart tap may not be completely deactivated, and, for example, only a communication unit may be kept on. The communication unit may communicate with a server immediately after the connected household electrical appliance is turned on.

The smart tap has a wake-up function of starting running when power supplied to the household electrical appliance becomes not less than the standby energy of the household electrical appliance after the entry into the sleep state and may be provided with a function of indicating the wake-up state with a light or the like.

The smart tap may be provided with a timer and may be turned on at an arbitrary time.

The wake-up function may be fulfilled by sensing a DC waveform or the like from a current waveform measurement unit provided in the smart tap.

It is also possible to create a sine wave with a pseudo AC waveform from an analog signal with a DC waveform from a current sensor and set a threshold value for power for wake-up and startup with use of a variable resistor. This allows fine adjustment of the threshold value between, e.g., 1 and 10 W. A tap starts up by sensing the running status of a household electrical appliance to be used when power is not less than the standby energy of the home appliance and enters a sleep state when the power is not more than the threshold value. In this manner, the power consumption of the tap itself can be reduced.

(Examples)

An apparatus using four MOSFETs per socket and intended to function as the mounted type electric outlet shown in Figure 6 was fabricated, and the fitness of the apparatus as a mounted type electric outlet capable of communication was evaluated through measurement of the temperature at the time of energization by a temperature evaluation apparatus.

Heating Temperature Actual Measurement Method

As a model for a mounted type electric outlet, current was supplied to a single MOSFET, and the heating temperature of the MOSFET itself was actually measured.

The measurement of the temperature was performed by SK-1250 (sensor (K)) having a measuring range of -30 to 500°C from Sato Keiryoki Mfg. Co., Ltd. that is a contact type thermometer.

- A TA (triac) (product number: BTA24-600CWRG) from STMicroelectronics was used as a semiconductor device.
- MOSFET-1 was a MOSFET from Infineon Technologies AG (IPP110N20N3 G: 10.7 m$\Omega$).
- MOSFET-2 was available from STMicroelectronics (STW77N65M5: 38 m$\Omega$).
- Since AC power is generally supplied, two MOSFETs are required per power plug socket for forward and reverse current and voltage control.

Note that the supplied AC current corresponds to supply of 7.5 A (15 A in the case of a parallel connection structure in Japan) and was intended for a serial connection structure in an overseas area where 200 V was used.

Computation of the amount of heat generation of each device is performed by

$$\text{H (W)} = (\text{current value}) \times (\text{current value}) \times (\text{resistance value}).$$

(Example 1 and Comparative Example)

As seen from Comparative Example, a triac (TA) had on resistance as high as 100 m$\Omega$, and the TA itself generated high heat. The amount of heat generation was as high as 23.3 W. For this reason, the triac was heated to a temperature off from practical use so that the actual measurement temperature was not less than 200°C and could not be actually measured.

In contrast, when MOSFET-1 was used instead of the TA, since the on resistance was as low as 10.7 m$\Omega$, the amount of heat generation was 0.6 W that was obviously lower than the case of the TA. It could be confirmed from an actual measurement temperature of 65°C that microcontroller control and the life of a communication control unit were not adversely affected.

When MOSFET-2 was used, since the on resistance was 38 mΩ, which was higher than that of MOSFCT-1, the amount of heat generation was 2.1 W and was higher. This resulted in an actual measurement temperature of over 100°C. Although the result was inferior to the result when MOSFET-2 was used, adoption of a further parallel connection structure for a smart tap or a heat dissipation design inside a plug apparatus actually allows use of MOSFET-2.

[Table 5]

|  | Comparative example | Example 1 | |
|---|---|---|---|
| Semiconductor device | TA | MOSFET-1 | MOSFET-2 |
| Supplied current value (A) | 7.5 | 7.5 | 7.5 |
| On resistance (mΩ) | 100 | 10.7 | 38 |
| The amount of heat generation (W) | 23.3 | 0.6 | 2.1 |
| Actual measurement temperature (°C) | >200 (not actually measurable) | 65 | >100 |

(Example 2)

MOSFLT-1 according to Example 1 was used. In Example 2, the effect of a change in the amount of heat generation on the life of a microcontroller control unit and the like was examined. It is required in terms of safety that the outer temperature of a power plug socket is less than 85°C. To prevent the microcontroller control unit from deteriorating, the temperature of a microcontroller control unit needs to be kept below 80°C, and a communication unit is required to be kept below 70°C because the communication unit has a crystal oscillator.

A result of Example 2 shows that the amount of heat generation of a single MOSFET needs to be 1.0 W to protect a microcontroller control unit and a communication unit from deterioration.

[Table 6]

|  | Example 2 | |
|---|---|---|
| MOSFET | MOSFET-1 | MOSFET-1 |
| Supplied current value (A) | 7.5 | 9.5 |
| The amount of heat generation (W) | 0.6 | 1.0 |
| Actual measurement temperature (°C) | 65 | 80 |

(Example 3)

MOSFET-2 according to Example 1 was used, and the heating temperature of an electric outlet structure in which MOSFETs are mounted to be connected in parallel with the layout shown in Figure 6 was actually measured.

Two units of MOSFET-2 connected in parallel were used. For example, if 10 A is supplied, and the number of units of MOSFET-2 is two, a current of 5A flows through each MOSFET.

A result shown in Table 7 below of actually measuring the heating temperature of each MOSFET in the actual electric outlet structure shows the actual measurement temperature is not more than 80°C when the amount of heat generation of the MOSFET is not more than 1 W. Since it can be seen that the amount of heat generation can be reduced to the amount of heat generation not more than 70°C when the amount of heat generation of the MOSFET is not more than 0.6 W, it is to be understood that the amount of heat generation of each MOSFET needs to be not more than 0.6 W, in particular, to prevent a communication unit from being overheated.

[Table 7]

|  | Example 3 | | |
|---|---|---|---|
| MOSFET | MOSFET-2 | MOSFET-2 | MOSFET-2 |
| Supplied current value (A) | 8 | 9 | 10 |
| The amount of current of one MOSFET (A) | 4 | 4.5 | 5 |

(continued)

|  | Example 3 | | |
|---|---|---|---|
| MOSFET | MOSFET-2 | MOSFET-2 | MOSFET-2 |
| The amount of heat generation of one MOSFET (W) | 0.61 | 0.77 | 1.0 |
| Actual measurement temperature (°C) | 67 | 73 | 80 |

According to the result, in a mounted type electric outlet which adopts a MOSFET of the type used in the example, each MOSFET generates more heat with increase in the value of a current applied to the MOSFET. Since the MOSFET that can reduce heat generation to not more than 1.0 W is used, the heating temperature can be improved to not more than 80°C, and reduction in the life of a microcontroller can be curbed. Note that if the amount of heat generation is 0.6 W, a communication unit including a crystal oscillator is in no danger of being heated to not less than 70°C.

If a triac is used, a metal heat dissipation plate needs to be formed at part of a box housing of an electric outlet for heat dissipation.

In contrast, use of a MOSFET allows reduction in the amount of heat generation and requires no metal heat dissipation plate or requires provision of a metal heat dissipation plate only at part inside an electric outlet box. Thus, the whole housing of the electric outlet box can be made of resin. The configuration has the advantage in that a communication unit can be provided inside an electric outlet to communicate with an external server.

Note that when a semiconductor device is used for power adjustment, an electric outlet using the semiconductor device can perform (1) interruption of power and (2) adjustment of the amount of power to each household electrical appliance, in particular, in response to an upper limit current value and a peak-cut power value in a server demand. The electric outlet can perform power adjustment of an energy-saving household electrical appliance by being equipped with an infrared ray remote control function as an extension.

As for power amount adjustment by the electric outlet, particularly control that prevents a peak-cut power value from being exceeded, a large margin for the amount of power is necessary for a mechanical relay which can perform on/off control but has a low response speed in order to guarantee the fact that an upper limit value is not exceeded.

However, use of a semiconductor device with a high response speed for the electric outlet allows adjustment that prevents the upper limit value for power from being exceeded through setting of a small margin. The adjustment that prevents the upper limit value from being exceeded is easier to guarantee.

(Example 4)

An example using a smart tap having the structure shown in Figure 7 will be described below.

IPP110N20N3 G from Infineon was used as MOSFET-3, and IRFB4332PbF from International Rectifier was used as MOSFET-4. Two MOSFETs of each type were connected in series and used per socket.

|  | Example 4 | |
|---|---|---|
| MOSFET | MOSFET-3 | MOSFET-4 |
| On resistance (m$\Omega$) | 11 | 29 |
| The amount of current of one MOSFET (A) | 15 | 15 |
| The amount of heat (W) | 2.475 | 6.525 |
| Microcontroller ambient temperature (°C) | <80 | <80 |
| Wireless communication unit ambient temperature (°C) | <80 | <80 |

According to Example 4, when two MOSFETs are used per socket, and a current of 15 (A) is supplied, even if the amounts of heat generation of the MOSFETs are as high as 2.475 W or 6.525 W, the temperatures of a microcontroller and a communication unit can be steadily kept at or below 80°C. This is accomplished by providing the MOSFETs on the side of an edge, such as a longer edge, of a board, adopting a housing made of, e.g., metal and excellent in thermal conductivity, and interposing an insulating heat dissipation sheet between the MOSFETs and the housing to let heat be dissipated toward the housing.

With this configuration, it is possible to make the number of MOSFETs used smaller than in the apparatuses according to Examples 1 to 3 and induce heat dissipated from a smart tap to the housing. Additionally, provision of the communication unit inside a front made of a member of, e.g., resin capable of letting radio waves pass therethrough of the smart tap allows communication toward the interior of a room.

(Example about Effectiveness of EoD Control System)

It will be demonstrated that an EoD control system according to the present invention can implement considerable power saving without impairing the QoL (the quality of life) through actual life.
Three subjects A, B, and C were subjected to a QoL demonstration experiment in the same smart apartment.
The living experiment used the smart home appliances and conventional home appliances below.

- Smart Home Appliances (Network-Based Power Control)
  Lights (in a living room and a bedroom), a television, an air conditioner, a microwave oven, a washing machine, a humidifier, a heater, and a rice cooker
- Conventional Home Appliances (Power Control Based on Smart Tap)
  Lights (in a hallway, a kitchen, a washroom, a toilet, and a bathroom), an electromagnetic cooker (1H), a refrigerator, an electric pot, and a toilet seat with a warm-water shower feature

(Experiment Description)

- Each subject spent a daily life without power saving and learned a standard pattern of power consumption.
- The subject spent a life in which integral power consumption for one day was 10% lower than the standard pattern and a life in which integral power consumption for one day was 30% lower.
- Obtained data were numerically analyzed, and effects of the lives with reduced power on QoL were evaluated.

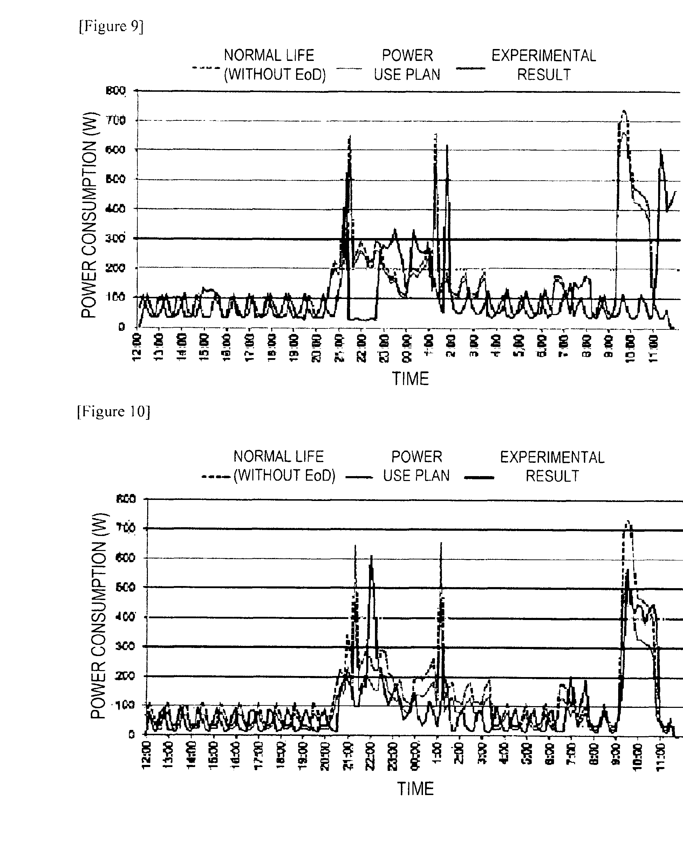

Figure 9 is a chart showing a pattern of power consumption at the time of normal use and respective patterns of instantaneous power in a power use plan and an experimental plan with a 10% reduction by a priority apparatus.
Figure 10 is a chart showing the pattern of power consumption at the time of normal use and respective patterns of instantaneous power in a power use plan and an experimental plan with a 30% reduction by the priority apparatus.
Figures 9 and 10 show that the conventional pattern of power consumption and the patterns of instantaneous power in the cases of a 10% reduction and a 30% reduction are similar and that an upper limit in the conventional pattern of power consumption is not exceeded.

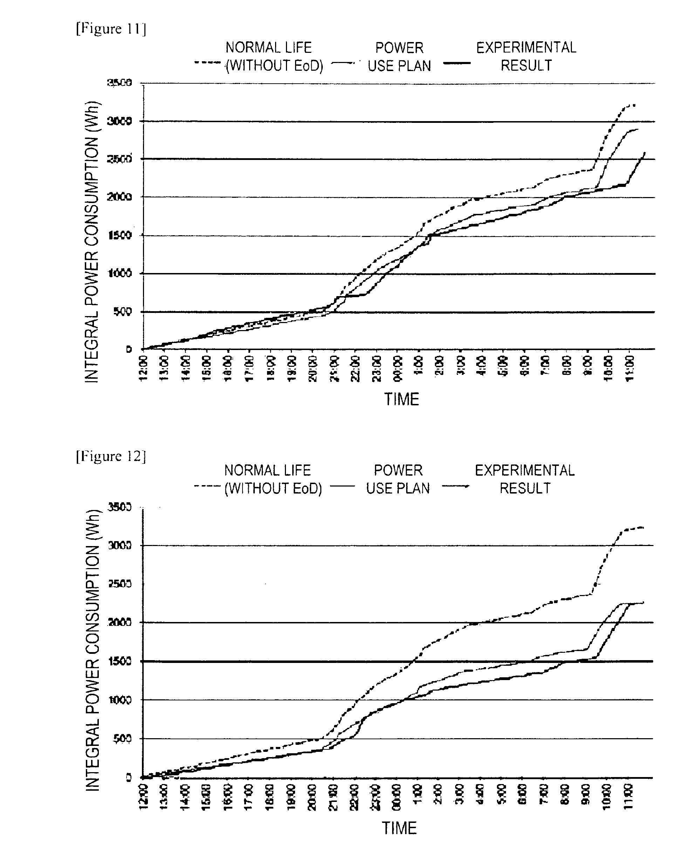

Figure 11 is a chart showing integral power consumption at the time of normal use and integral power consumption in the power use plan and the experimental plan with a 10% reduction by the priority apparatus.
Figure 12 is a chart showing the integral power consumption at the time of normal use and integral power consumption in the power use plan and the experimental plan with a 30% reduction by the priority apparatus.
In both of the 10% and 30% reduction cases, integral power consumption at the time of normal use, integral power consumption based on an initial target value, and integral power consumption based on actually used power are mostly ranked in that order from highest to lowest. Figures 11 and 12 show that an upper limit for conventional integral power consumption is not exceeded.
Values in Figures 9 to 12 show that power consumption and integral power consumption are reduced even without changing the pattern of a daily life.
We listened to the actual life experience of the three subjects and checked whether there was any problem in the smart apartment where the EoD control system was installed.

(Actual Life Experience of Three Subjects)

- Subjects A. B, and C
  Overall, they could live without any particular inconvenience, regardless of rate of power reduction.
- Subject A
  He/she was conscious of a power reduction life only when the lighting was poor or the picture on the TV screen was not bright enough and cared no longer about the power reduction life when he/she got used to it.
- Subject B
  He/she was conscious only when the electric pot was slower in boiling water and cared no longer about the power reduction life when he/she got used to it.
- Subject C

He/she reduced power for home appliances other than those for cooking at the peak of cooking.

It was found from the actual life experience of the three subjects that a person could live without any particular inconvenience, regardless of rate of power reduction (10% or 30%).

## Claims

1. A smart tap (C) into which one or more power plugs can be inserted, comprising:

  a voltage waveform measurement unit,
  a current waveform measurement unit (2),
  a communication unit (4),
  a control unit (11), and
  an arithmetic unit (3),
  wherein the voltage waveform measurement unit and the current waveform measurement unit (2) are adapted to measure a voltage waveform and a current waveform, respectively, of power supplied to each of one or more home appliances (T) via a corresponding one of respective power plugs connected to the home appliances (T), and wherein the communication unit (4) is adapted to transmit the voltage waveform and the current waveform or a result of processing of the waveforms to a server which is installed in a place separate from the smart tap (C) and further adapted to receive a control signal based on a result of computation in the server, and wherein the control unit (11) is adapted to control switching of the power supplied to the home appliance (T) and the amount of the supplied power in accordance with the control signal, **characterized in that** the control unit (11) is further adapted to control the amount of the power supplied to each of the home appliances (T) with the power plugs connected to the smart tap (C) on the basis of data on the amount of suppliable power received from the server, and wherein the smart tap (C) further comprises a sensing unit adapted to analyze the waveforms obtained from the voltage waveform measurement unit and the current waveform measurement unit (2) and to recognize a status of and senses an abnormality in each home appliance, and a sensing and communication unit adapted to transmit a sensing result from a sensor which is installed in a building to the server.

2. The smart tap (C) according to claim 1, for being supplied by a plurality of power sources.

3. The smart tap (C) according to claim 1 or 2, further comprising a mounted type electric outlet which is mounted in a wall portion, a ceiling portion, a floor portion, or the like of a house or a tap which is connected to a mounted type electric outlet or a tap.

4. The smart tap (C) according to one of claims 1 to 3, wherein the smart tap (C) is installed in a facility into which a single power source or a plurality of power sources selected from among a plurality of power sources including system power, photovoltaic power generation (PV), wind power generation, small hydropower generation, a fuel cell, and a storage battery are led.

## Patentansprüche

1. Intelligente Anzapfung (C), in die ein oder mehrere Netzstecker eingesteckt werden können, umfassend:

  eine Spannungskurven-Messeinheit,
  eine Stromkurven-Messeinheit (2),
  eine Kommunikationseinheit (4),
  eine Steuereinheit (11) und
  eine Recheneinheit (3),
  wobei die Spannungskurven-Messeinheit und die Stromkurven-Messeinheit (2) eine Spannungskurve bzw. eine Stromkurve von Energie messen sollen, die jeweils einem oder mehreren Haushaltsgeräten (T) über einen entsprechenden der jeweiligen, mit den Haushaltsgeräten (T) verbundenen, Netzstecker zugeführt wird, und wobei die Kommunikationseinheit (4) die Spannungskurve und die Stromkurve oder eine Ergebnis der Verarbeitung der Wellenformen zu einem Server übertragen soll, der an einer Stelle getrennt von der intelligenten Anzapfung (C) installiert ist, und ferner ein Steuersignal basierend auf einem Berechnungsergebnis in dem Server empfangen soll,

und wobei die Steuereinheit (11) das Schalten von der dem Haushaltsgerät (T) zugeführten Energie und die Höhe der zugeführten Energie in Übereinstimmung mit dem Steuersignal steuern soll,

**dadurch gekennzeichnet, dass**

die Steuereinheit (11) des Weiteren die Höhe der jedem der Haushaltsgeräte (T) zugeführten Energie mit den an die intelligente Anzapfung (C) angeschlossenen Netzsteckern auf der Basis von Daten hinsichtlich der Höhe zuführbarer Energie, die von dem Server empfangen werden, steuern soll,

und wobei die intelligente Anzapfung (C) ferner eine Abtasteinheit, die die von der Spannungskurven-Messeinheit und der Stromkurven-Messeinheit (2) erhaltenen Wellenformen analysieren und einen Status davon erkennen soll, und eine Abnormität in jedem Haushaltsgerät abtastet, sowie eine Abtast- und Kommunikationseinheit aufweist, die ein Abtastergebnis von einem Sensor, der in einem Gebäude installiert ist, zu dem Server übertragen soll.

2. Intelligente Anzapfung (C) nach Anspruch 1, zum Speisen durch eine Vielzahl von Energiequellen.

3. Intelligente Anzapfung (C) nach Anspruch 1 oder 2, des Weiteren umfassend eine montierte elektrische Anschlussstelle, die in einem Wandabschnitt, einem Deckenabschnitt, einem Fußbodenabschnitt oder dergleichen eines Hauses angebracht ist, oder eine Anzapfung, die mit einer montierten elektrischen Anschlussstelle oder einem Abzweig verbunden ist.

4. Intelligente Anzapfung (C) nach einem der Ansprüche 1 bis 3, wobei die intelligente Anzapfung (C) in einer Anlage installiert ist, in die eine einzelne Energiequelle oder eine Vielzahl von Energiequellen geführt werden, die unter einer Vielzahl von Energiequellen einschließlich Systemleistung, Fotovoltaik-Energieerzeugung (PV), Windkrafterzeugung, kleine Wasserkrafterzeugung, einer Brennstoffzelle und einem Akkumulator ausgewählt sind.

## Revendications

1. Prise intelligente (C) dans laquelle peuvent être branchées une ou plusieurs fiches d'alimentation mâles, comprenant :

une unité de mesure de forme d'onde de tension,
une unité de mesure de forme d'onde de courant (2),
une unité de communication (4),
une unité de commande (11), et
une unité arithmétique (3),
dans laquelle l'unité de mesure de forme d'onde de tension et l'unité de mesure de forme d'onde de courant (2) sont adaptées à mesurer respectivement une forme d'onde de tension et une forme d'onde de courant, d'une puissance électrique fournie à chacun d'un ou plusieurs appareils domestiques (T) par l'intermédiaire d'une fiche correspondante des fiches d'alimentation mâles respectives reliées aux appareils domestiques (T), et dans laquelle l'unité de communication (4) est adaptée à transmettre la forme d'onde de tension et la forme d'onde de courant ou le résultat du traitement des formes d'ondes, à un serveur qui est installé à un emplacement distinct de la prise intelligente (C), et adaptée en outre à recevoir un signal de commande en se fondant sur le résultat d'un calcul dans le serveur,
et dans laquelle l'unité de commande (11) est adaptée à commander la commutation de la puissance électrique fournie à l'appareil domestique (T) et la valeur de la puissance électrique fournie en fonction du signal de commande,
**caractérisée en ce que**
l'unité de commande (11) est adaptée en outre à commander la valeur de la puissance électrique fournie à chacun des appareils domestiques (T), les fiches d'alimentation mâles étant branchées à la prise intelligente (C), en se fondant sur les données relatives à la valeur de la puissance électrique pouvant être fournie, reçues depuis le serveur,
et dans laquelle le prise intelligente (C) comprend en outre une unité de détection adaptée à analyser les formes d'ondes obtenues à partir de l'unité de mesure de forme d'onde de tension et l'unité de mesure de forme d'onde de courant (2) et à reconnaître l'état de et à détecter une anomalie dans chaque appareil domestique, et une unité de détection et de communication adaptée à transmettre au serveur un résultat de détection provenant d'un capteur qui est installé dans un bâtiment.

**2.** Prise intelligente (C) selon la revendication 1, destiné à être alimenté par une pluralité de sources d'énergie électrique.

**3.** Prise intelligente (C) selon la revendication 1 ou 2, comprenant en outre une prise électrique du type monté qui est montée sur une partie murale, une partie de plafond, une partie de plancher ou analogue d'une maison ou un prise intelligente qui est connecté à une prise électrique de type monté ou une prise intelligente.

**4.** Prise intelligente (C) selon l'une des revendications 1 à 3, dans laquelle la prise intelligente (C) est installée dans une installation dans laquelle sont disposées une source d'alimentation unique ou une pluralité de sources d'alimentation choisies parmi une pluralité de sources d'alimentation incluant une alimentation de système, un générateur d'énergie photovoltaïque (PV), un générateur d'énergie éolienne, un petit générateur hydroélectrique, une pile à combustible et une batterie de stockage.

[Figure 1]

VOLTAGE AND CURRENT
WAVEFORMS OF HAIR DRYER

VOLTAGE AND CURRENT
WAVEFORMS OF CLEANER

[Figure 2]

[Figure 3a]

[Figure 3b]

[Figure 4]

SOCKET 1 SOCKET 2

CURRENT WAVEFORM MEASUREMENT UNIT

VOLTAGE WAVEFORM MEASUREMENT UNIT

CONTROL UNIT

CURRENT WAVEFORM MEASUREMENT UNIT

VOLTAGE WAVEFORM MEASUREMENT UNIT

CONTROL UNIT

INPUT

WIRELESS COMMUNICATION UNIT

MICROCONTROLLER CONTROL UNIT

[Figure 5]

TRANSMISSION NETWORK

SOLAR CELL STORAGE BATTERY

[Figure 6]

[Figure 7]

[Figure 8]

[Figure 9]

[Figure 10]

[Figure 11]

[Figure 12]

**REFERENCES CITED IN THE DESCRIPTION**

**Patent documents cited in the description**

- JP 2008104310 A
- JP 2008261826 A
- JP 2011010000 A
- JP 2011072099 A
- JP 2011078177 A